# EUROPEAN PATENT APPLICATION

(11) **EP 2 090 637 A1**
(43) Date of publication of application: **19.08.2009**
(21) Application number: 08254201.0
(22) Date of filing: 31.12.2008
(51) Int. Cl.: C09K 11/06, H05B 33/14, C07F 7/08, H01L 51/00

(54) **Organic electroluminescent compounds and light emitting diode using the same**

(30) Priority: 31.12.2007 KR 20070142006
(71) Applicant: Gracel Display Inc., Seoul 133-833 (KR)
(72) Inventor: Lee, Mi Ae, Mapo-gu Seoul, 121-190 (KR); Kim, Chi Sik, Seoul 156-825 (KR); Cho, Young Jun, Seongbuk-gu Seoul 130-060 (KR); Kwon, Hyuck Joo, Dongdaemun-gu Seoul, 130-100 (KR); Kim, Bong Ok, Gangnam-gu Seoul 135-090 (KR); Kim, Sung Min, Seoul-city 157-886 (KR); Yoon, Seung Soo, Gangnam-gu Seoul 145-884 (KR)
(74) Representative: Kent, Venetia Katherine

(57) **Abstract**

The present invention relates to organic electroluminescent compounds represented by Chemical Formula (1), and organic light emitting diodes comprising the same. Since the organic electroluminescent compounds according to the invention have good luminous efficiency and life propertyof material, OLED's having very good operation lifetime can be produced. 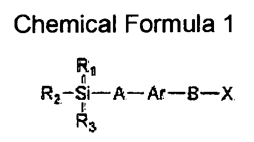 wherein, X represents

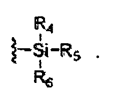

## Description

### FIELD OF THE INVENTION

The present invention relates to organic electroluminescent compounds and organic light emitting diodes (OLED's) comprising the same.

### BACKGROUND OF THE INVENTION

As the modern society comes into information-oriented age, the importance of a display, which plays a role of interface between the electronic information device and human being, is getting significant. As a novel planar display technique, OLED's have been actively investigated all over the world, since OLED's show excellent display property as self-luminescent devices, and the manufacture is easy because of simple device structure, and ultra-thin and ultra-light weight displays can be manufactured.

An OLED device usually consists of a plurality of thin layers of organic compounds between the cathode and anode made of metal. Electrons and holes injected through the cathode and anode are transmitted to an electroluminescent layer via an electron injection layer and an electron transportation layer, a hole injection layer and a hole transport layer to form excitons, which degrade into stable state to emit light. In particular, the properties of an OLED largely depend on the properties of the organic electroluminescent compound employed. Accordingly investigations on core organic materials having enhanced performances have been actively achieved.

The core organic materials are classified into electroluminescent materials, and carrier injection and transport materials. The electroluminescent materials can be classified into host materials and dopant materials. Usually, as the device structure with most excellent EL properties, structures comprising a core organic thin film layer employing host-dopant doping system have been known.

Recently, small size displays are practically used, so that development of OLED's with high efficiency and long life is raising as an urgent subject. This would be an important milestone in the field of practical use of medium to large size OLED panels. Thus, development of core organic materials having more excellent properties as compared to conventional core organic materials is urgently required. From this point of view, development of host materials, and carrier injection and transport materials is one of the important subjects to be addressed.

Desirable properties for host material as solid state solvent and energy deliverer or material for carrier injection or delivery in an OLED are high purity and appropriate molecular weight to enable vapor-deposition in vacuo. In addition, they should ensure thermal stability with high glass transition temperature and thermal decomposition temperature, and they should have high electrochemical stability for long life of the product, and easily form an amorphous thin layer. Particularly, it is very important for them to have good adhesion with the material of other adjacent layers, along with rare occurrence of interlayer migration.

Conventional host materials include diphenylvinyl-biphenyl (DPVBi) from Idemitsu-Kosan and dinaphthyl-anthracene (DNA) from Kodak, but still requiring further improvements in terms of efficiency, life and color purity.

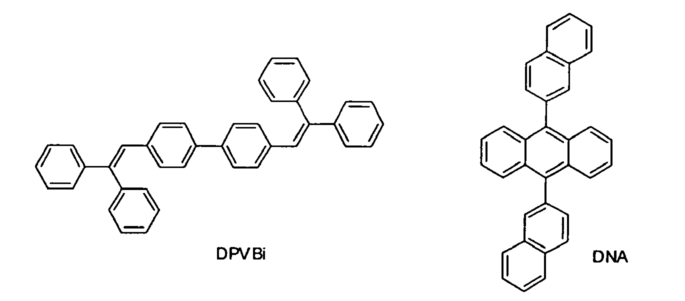

Since DPVBi shows poor thermal stability with the glass transition temperature of not more than 100°C, DPVPAN and DPVPBAN have been developed wherein anthracene and dianthracene was incorporated inside the biphenyl of DPVBi, respectively. Though the thermal stability thereof was enhanced by raising the glass transition temperature of 105°C or higher, the compounds did not exhibit color purity or luminous efficiency in a satisfactory level.

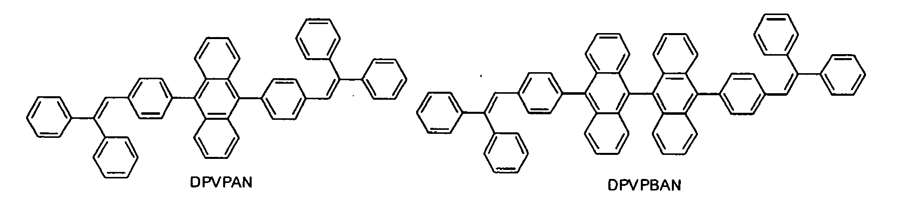

In the meanwhile, when a thin film formed from DNA by vacuum vapor-deposition on an ITO was observed by an atomic microscope, crystallization frequently occurs because of poor stability of the thin film. Such a phenomenon gives ill influence on the device life. In order to overcome foregoing disadvantage of DNA, mDNA and tBDNA were developed (wherein methyl or t-butyl group is incorporated at 2-position of DNA) in order to destroy the molecular symmetry and improve the film stability, but color purity and luminous efficiency of those compounds were not satisfactory yet.

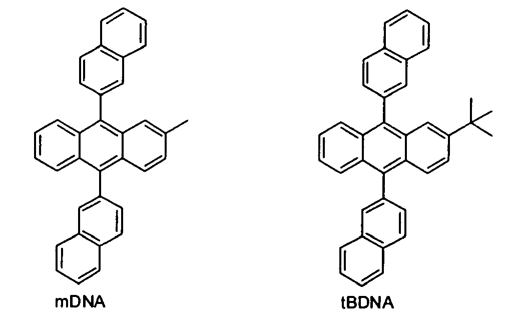

In order to develop a host material with high efficiency and long life, electroluminescent (EL) compounds based on different backbones have been disclosed, such as dispiro-fluorene-anthracene (TBSA), ter-spirofluorene (TSF) and bitriphenylene (BTP). These compounds, however, did not result in color purity and luminous efficiency in a sufficient level.

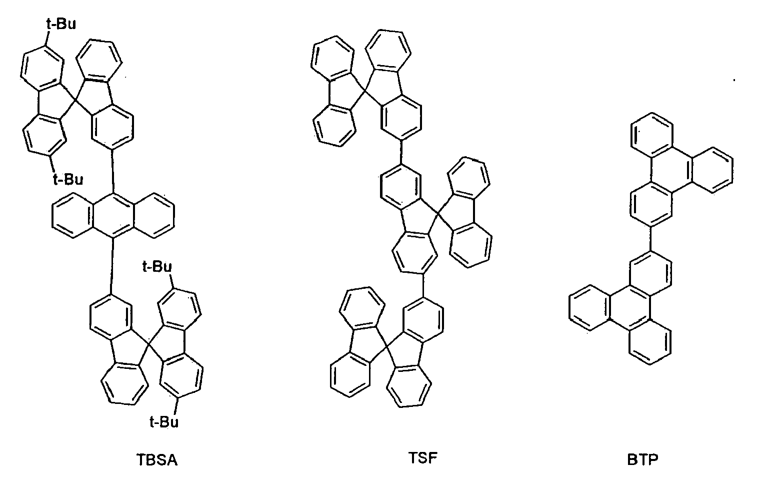

The compound TBSA as reported by Gyeongsang National University and Samsung SDI (Kwon, S. K. et al., Advanced Materials, 2001, 13, 1690; Japanese Patent Laid-Open JP 2002121547), showed luminous efficiency of 3 cd/A at 7.7 V, and relatively good color coordinate of (0.15, 0.11), but it was known to be inappropriate for practical use.

The compound TSF reported by Taiwan National University (Wu, C. -C. et al., Advanced Materials, 2004, 16, 61; US Patent Publication US 2005040392) showed relatively good external quantum efficiency of 5.3%, but it is still insufficient for practical use.

The compound BTP reported by Chingwha National University of Taiwan (Cheng, C. -H. et al., Advanced Materials, 2002, 14, 1409; US Patent Publication 2004076852) showed luminous efficiency of 2.76 cd/A and relatively good color coordinate of (0.16, 0.14), but this was still insufficient for practical use.

As a host material for phosphorescent light emitting material, 4,4'-N,N'-dicarbazole-biphenyl (CBP) has been most widely known up to the present, and OLED's having high efficiency to which a hole blocking layer (such as BCP and BAlq) had been applied have been developed. Pioneer (Japan) or the like reported OLED's of high performances which were developed by using bis(2-methyl-8-quinolinato)(p-phenylphenolato)aluminum (III) (BAlq) derivatives as the host.

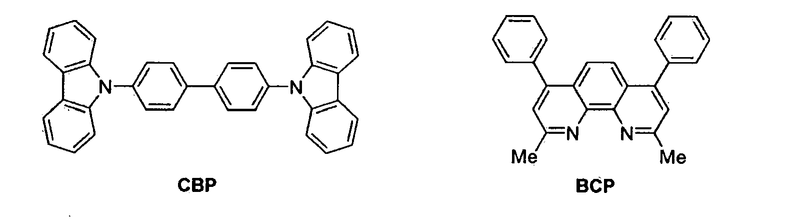

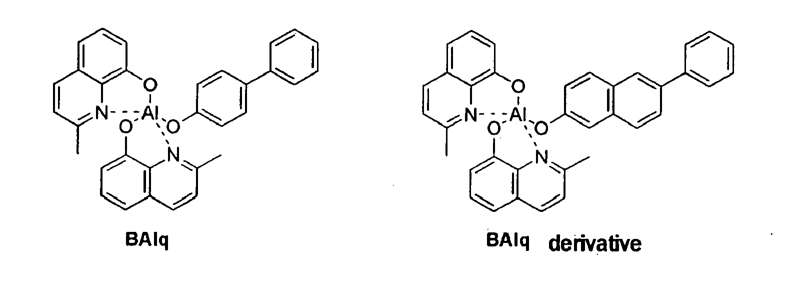

Though the materials in prior art are advantageous in view of light emitting property, they have low glass transition temperature and very poor thermal stability, so that the materials tend to be changed during the process of high temperature vapor-deposition in vacuo. In an OLED, it is defined that power efficiency = (π /voltage) x current efficiency. Thus, the power efficiency is inversely proportional to the voltage, and the power efficiency should be higher in order to obtain lower power consumption of an OLED. In practice, an OLED employing phosphorescent electroluminescent (EL) material shows significantly higher current efficiency (cd/A) than an OLED employing fluorescent EL material. However, in case that a conventional material such as BAlq and CBP was employed as host material of the phosphorescent material, no significant advantage could be obtained in terms of power efficiency (lm/w) because of higher operating voltage as compared to an OLED employing a fluorescent material.

Further, lifetime of the OLED's manufactured therefrom cannot be in satisfactory level by any means. Thus, development of host material having better stability and far improved performances is demanded.

### SUMMARY OF THE INVENTION

Thus, the object of the invention is to overcome the problems described above and to noticeably improve the properties of host (which serves as solvent or an energy deliverer in the electroluminescent material) as compared to conventional materials, thereby providing organic electroluminescent compounds exhibiting high luminous efficiency and excellent power efficiency and lifetime of device operation. Another object of the invention is to provide organic light emitting diodes comprising the novel organic electroluminescent compounds described above.

Still another object of the present invention is to provide organic solar cells comprising said novel organic electroluminescent compounds.

Specifically, the present invention relates to novel organic electroluminescent compounds represented by Chemical Formula (1), and organic light emitting diodes comprising the same. The organic electroluminescent compounds according to the invention is advantageous to provide OLED's having good luminous efficiency and power efficiency, and excellent operation lifetime of device. 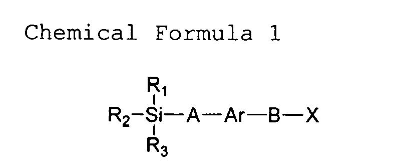 wherein,
A and B independently represent a chemical bond, or (C6-C60)arylene with or without one or more substituent(s) selected from linear or branched and saturated or unsaturated (C1-C60)alkyl with or without halogen substituent(s), (C1-C30)alkoxy, (C6-C60)aryl, (C5-C60)heteroaryl and halogen, excluding the case wherein both A and B represent anthrylene;
Ar represents (C6-C60)arylene or (C5-C60)heteroarylene, provided that Ar necessarily represents 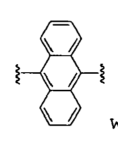 when both A and B represent chemical bonds;
the arylene or heteroarylene of Ar may be further substituted by one or more substituent(s) selected from deuterium, linear or branched and saturated or unsaturated (C1-C60)alkyl with or without halogen substituent(s), (C1-C30)alkoxy, (C6-C60)aryl, (C5-C60)heteroaryl and halogen;
R₁ through R₃ independently represent linear or branched and saturated or unsaturated (C1-C60)alkyl, (C6-C60)aryl or (C5-C60)heteroaryl; and the alkyl or aryl of R₁ through R₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl;
X represents 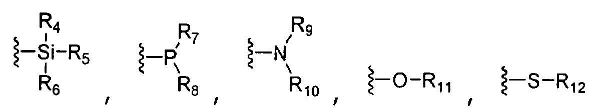 or 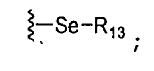 and
R₄ through R₁₃ independently represent linear or branched and saturated or unsaturated (C1-C60)alkyl, (C6-C60)aryl or (C5-C60)heteroaryl; and the alkyl or aryl of R₄ through R₁₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl.

### BRIEF DESCRIPTION OF THE DRAWINGS

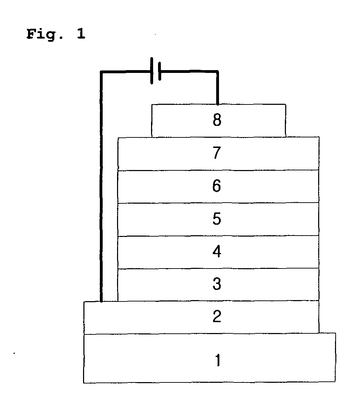

Fig. 1 is a cross-sectional view of an OLED.

### DETAILED DESCRIPTION OF THE INVENTION

Referring now to the Drawings, Fig. 1 illustrates a cross-sectional view of an OLED of the present invention comprising a Glass 1, a Transparent electrode 2, a Hole injection layer 3, a Hole transport layer 4, an Electroluminescent layer 5, an Electron transport layer 6, an Electron injection layer 7 and an Al cathode 8.

If there is no element in A or B of Chemical Formula (1), but Si and Ar are simply bonded, it is referred to as 'a chemical bond', and the arylene or heteroarylene includes multiple arylenes or heteroarylenes linked via chemical bond(s).

The term 'aryl' described herein specifically refers an aromatic group such as phenyl, naphthyl, biphenyl, tetrahydronaphthyl, indenyl, fluorenyl, phenathrenyl, anthracenyl, triphenylenyl, pyrenyl, chrysenyl and naphthacenyl. The term 'heteroaryl' refers a 5- or 6-membered aromatic ring containing one or more heteroatom(s) selected from N, O and S, such as pyrrole, pyrazole, oxazole, isoxazole, thiazole, isothiazole, imidazole, oxadiazole, thiadiazole, pyridine, pyrazine, pyrimidine and pyridazine.

Specific examples of the 5- or 6-membered heteroaromatic ring with a (C6-C20)aromatic ring fused include indazole, benzoxazole, benzothiazole, benzimidazole, phthalazine, quinoxaline, quinazoline, cinnoline, carbazole, phenanthridine, acridine, quinoline and isoquinoline.

The term 'alkyl' or 'alkoxy' described herein includes both linear and branched species.

The arylene or heteroarylene of Ar in Chemical Formula (1) is selected from the following structures: 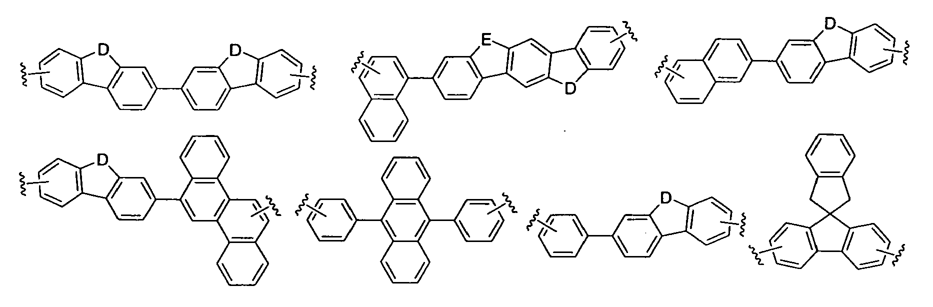 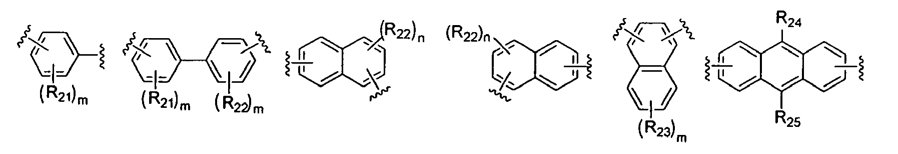 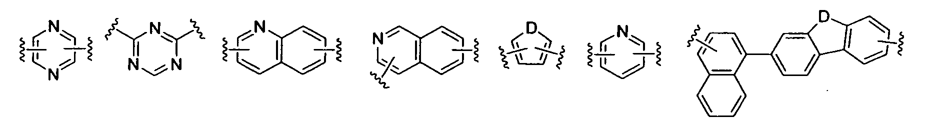 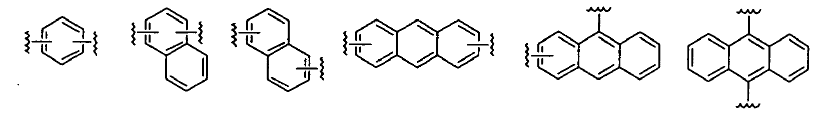 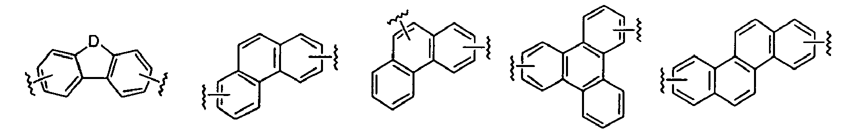 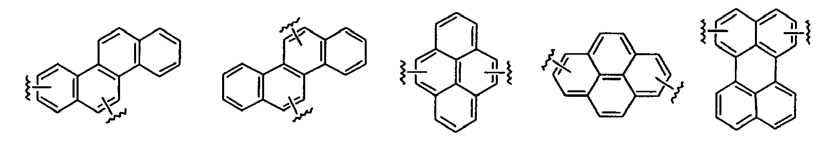 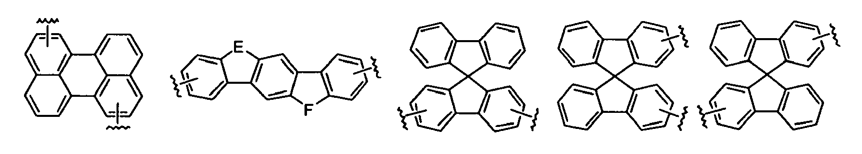 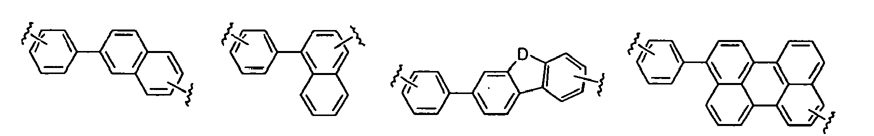 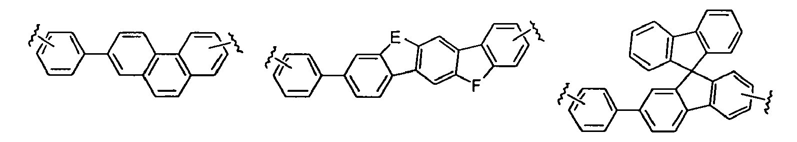 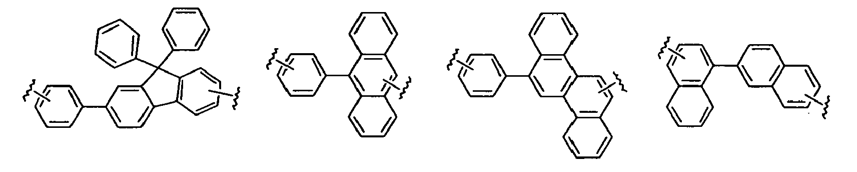 wherein, D, E and F independently represent CR₃₁R₃₂, NR₃₃, O or S,
R₂₁, R₂₂, R₂₃, R₂₄ and R₂₅ independently represent linear or branched and saturated or unsaturated (C1-C60)alkyl, (C1-C30)alkoxy, halogen or (C6-C60)aryl;
R₃₁, R₃₂ and R₃₃ independently represent linear or branched and saturated or unsaturated (C1-C60)alkyl or (C6-C60)aryl;
the alkyl, alkoxy or aryl of R₂₁, R₂₂, R₂₃, R₂₄, R₂₅, R₃₁, R₃₂ and R₃₃ may be further substituted by halogen, or linear or branched (C1-C60)alkyl;
m is an integer from 0 to 4; and
n is an integer from 0 to 3.

Preferably, A and B of Chemical Formula (1) independently represent phenylene, biphenylene, naphthylene, fluorenylene, spirobifluorenylene, phenanthrylene, triphenylenylene, pyrenylene, chrysenylene or naphthacenylene, and A and B may be further substituted by one or more substituent(s) selected from (C1-C60)alkyl, (C1-C30)alkoxy, halogen, phenyl, naphthyl, anthryl, fluorenyl, 9,9-dimethyl-fluoren-2-yl and 9,9-diphenyl-fluoren-2-yl.

In Chemical Formula (1), R₁ through R₃ may be independently selected methyl, ethyl, n-propyl, i-propyl, i-butyl, t-butyl, n-pentyl, i-amyl, n-hexyl, n-heptyl, n-octyl, 2-ethylhexyl, n-nonyl, decyl, dodecyl, hexadecyl, trifluoromethyl, pentafluoroethyl, phenyl, benzyl, tolyl, 2-fluorophenyl, 4-fluorophenyl, biphenyl, naphthyl, anthryl, phenanthryl, naphthacenyl, fluorenyl, 9,9-dimethyl-fluoren-2-yl, pyrenyl, phenylenyl or fluoranthenyl.

The organic electroluminescent compounds according to the present invention can be specifically exemplified by the following compounds, but they are not restricted thereto.

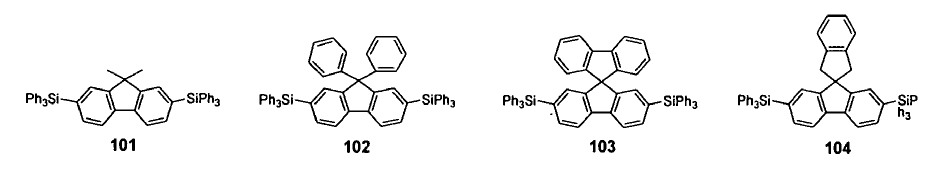

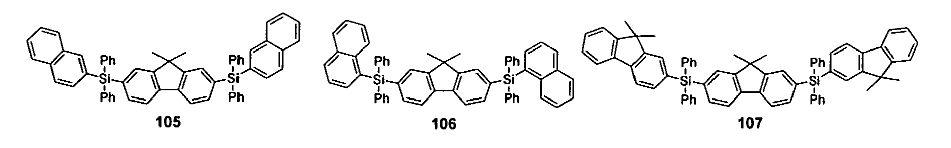

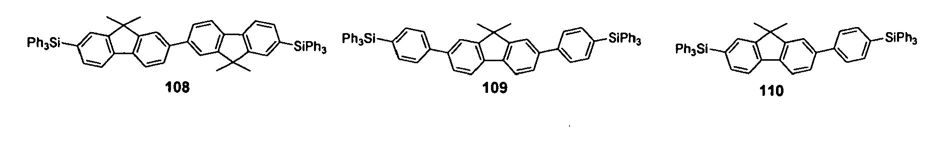

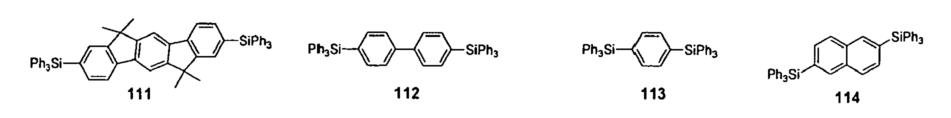

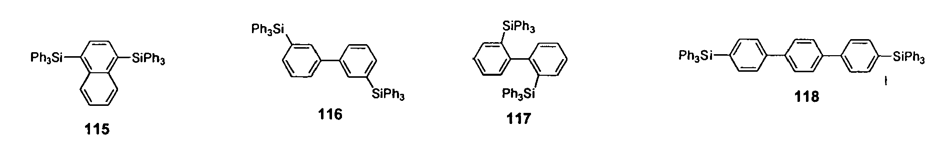

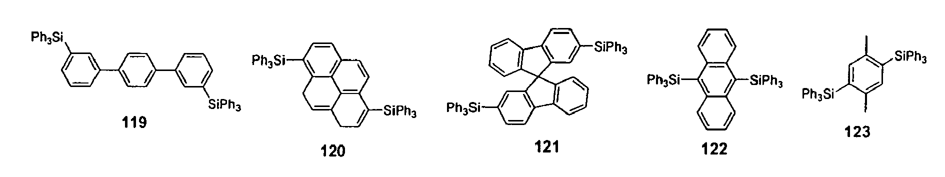

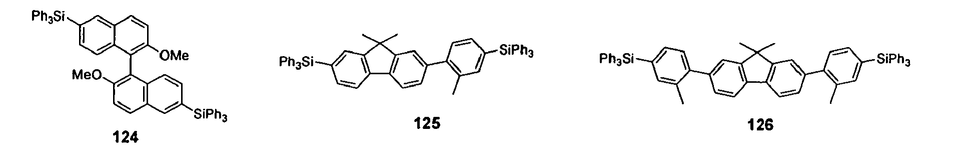

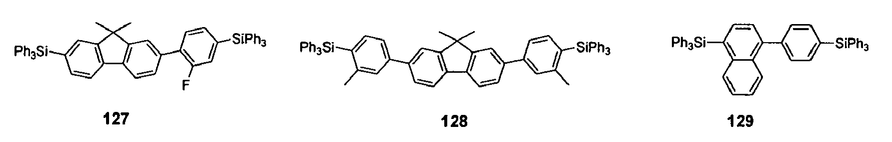

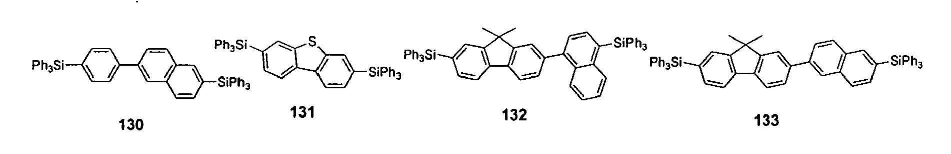

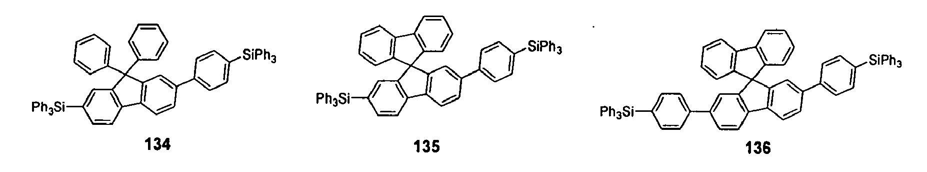

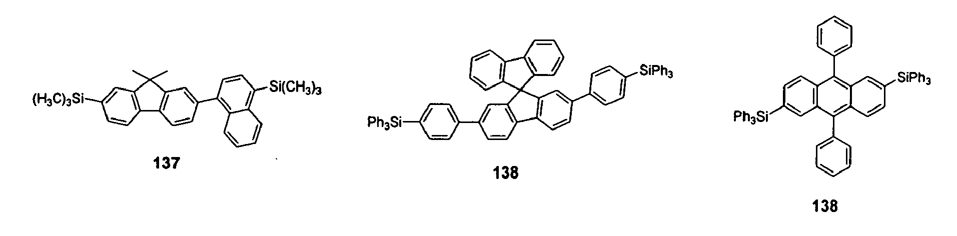

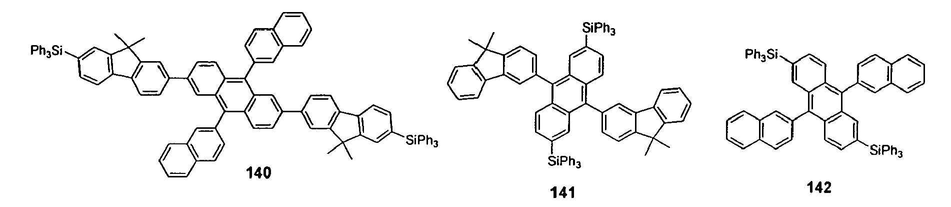

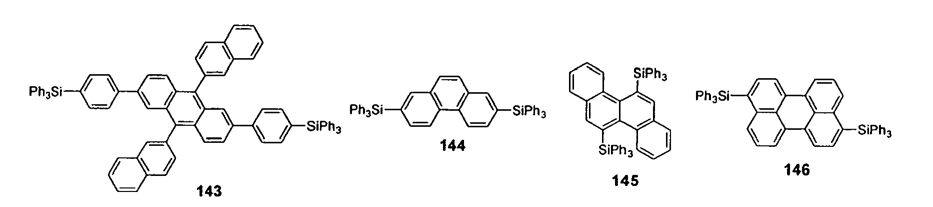

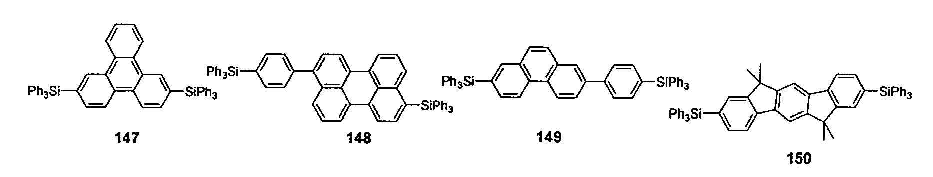

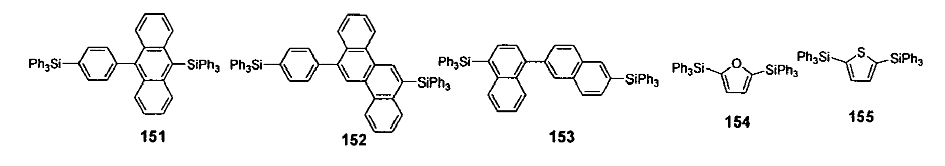

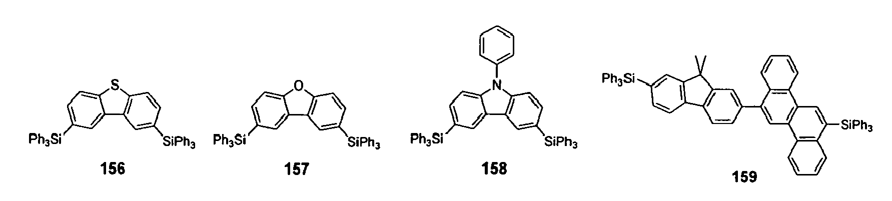

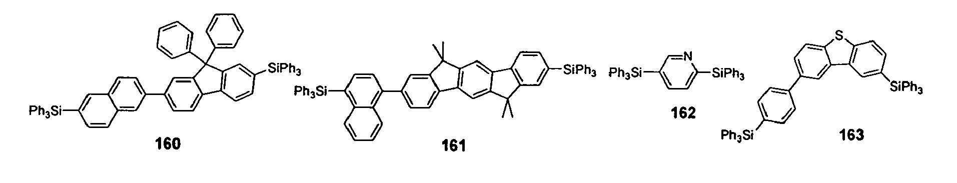

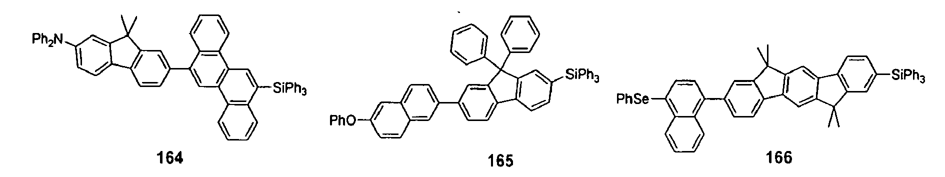

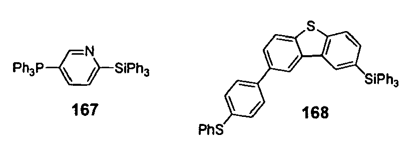

The organic electroluminescent compounds according to the present invention can be prepared via reaction route illustrated by Reaction Scheme (1): 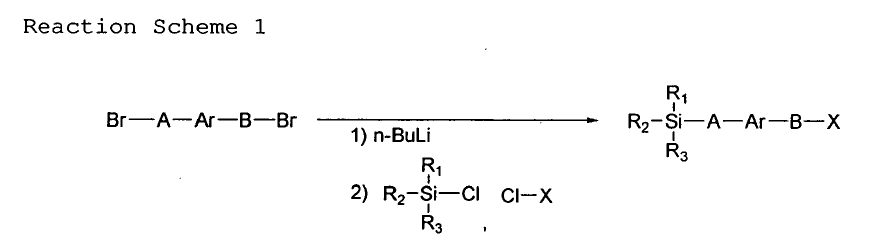 wherein, A, B, Ar, R₁, R₂, R₃ and X are defined as in Chemical Formula (1).

In addition, the present invention provides organic solar cells, which comprise one or more organic electroluminescent compound(s) represented by Chemical Formula (1).

The present invention also provides an organic light emitting diode which is comprised of a first electrode; a second electrode; and at least one organic layer(s) interposed between the first electrode and the second electrode; wherein the organic layer comprises one or more compound(s) represented by Chemical Formula (1).

The organic light emitting diode according to the present invention is characterized in that the organic layer comprises an electroluminescent region, and the region comprises one or more compound(s) represented by Chemical Formula (1) as electroluminescent host in an amount from 1 to 20% by weight, and one or more electroluminescent dopant(s).

The electroluminescent dopant applied to the electroluminescent device according to the invention is not particularly restricted, but may be exemplified by the compounds represented by one of Chemical Formulas (2) to (4), in case of blue one:

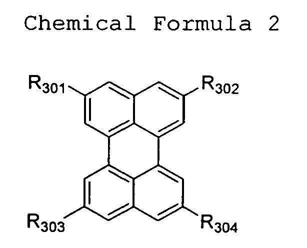

In Chemical Formula (2), R₃₀₁ through R₃₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(Cl-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkyloxy, aryloxy, arylthio, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro and hydroxyl.

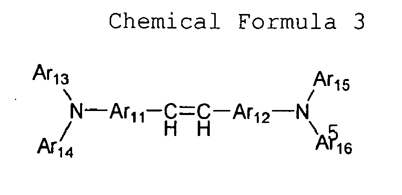

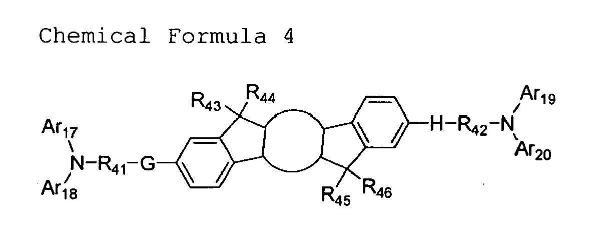

In Chemical Formula (3) and (4), Ar₁₁ and Ar₁₂ independently represent substituted or unsubstituted (C6-C60)arylene, substituted or unsubstituted (C5-C60)heteroarylene, or indenofluorene, fluorene or spirofluorene shown below:

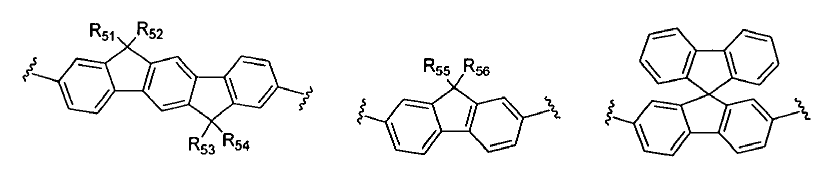

Ar₁₃ through Ar₁₆ are independently selected from (C6-C60)aromatic rings, (C5-C60)heteroaromatic rings and polycyclic aromatic rings; provided that Ar₁₁ and Ar₁₂ may be same or different, Ar₁₃ and Ar₁₅ may be same or different, and Ar₁₄ and Ar₁₆ may be same or different;
Ar₁₇ through Ar₂₀ independently represent a (C5-C60)aromatic ring, a (C5-C60)heteroaromatic ring, or a fused polycyclic aromatic ring with two or more aromatic rings being fused; 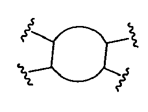 represents 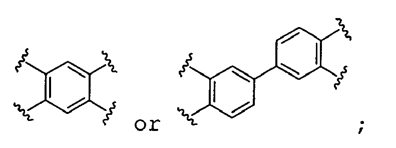 G and H independently represent a chemical bond, 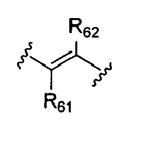 or 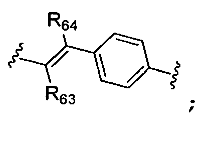 R₄₁ and R₄₂ independently represent (C5-C60)aromatic ring, (C5-C60)heteroaromatic ring, or a fused polycyclic aromatic ring with two or more aromatic rings being fused;
R₄₃ through R₄₆ independently represent linear or branched (C1-C60)alkyl with or without halogen, substituted or unsubstituted (C6-C50)aryl, substituted or unsubstituted (C5-C50)heteroaryl, or halogen;
R₅₁ through R₅₆ are independently selected from (C1-C60)alkyl, substituted or unsubstituted (C6-C50)aryl, substituted or unsubstituted (C5-C50)heteroaryl, halogen, and phenyl or naphthyl with or without (C1-C60)alkyl substituent; and
R₆₁ through R₆₄ independently represent hydrogen, deuterium, halogen or (C5-C60)aromatic ring.

The compounds represented by Chemical Formula (2) or (4) may be specifically exemplified by the followings: 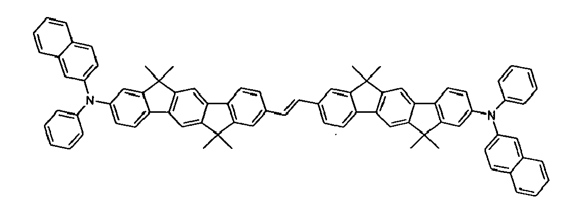 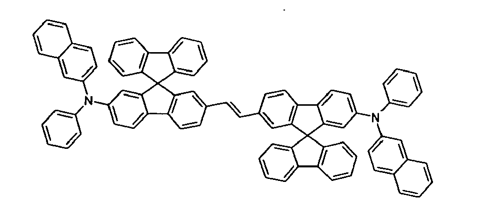 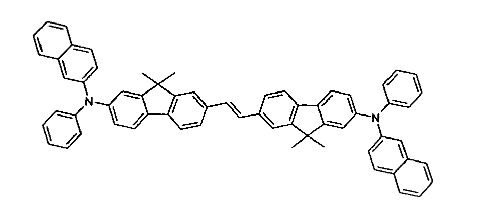 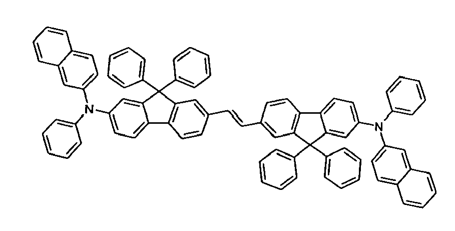 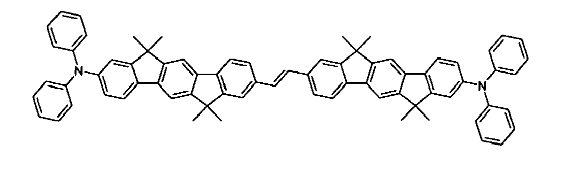 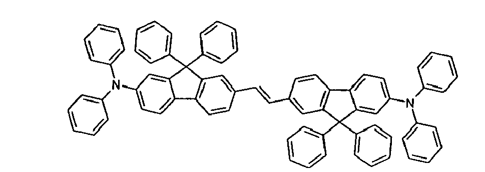 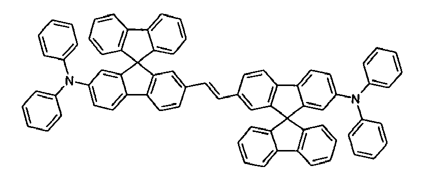 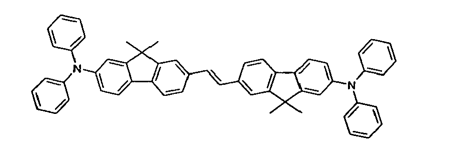 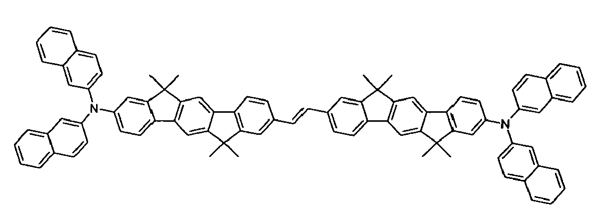 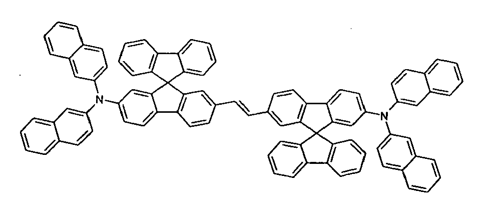 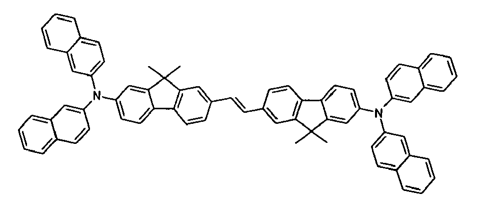 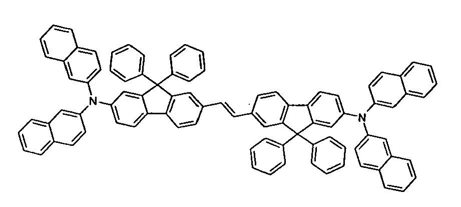 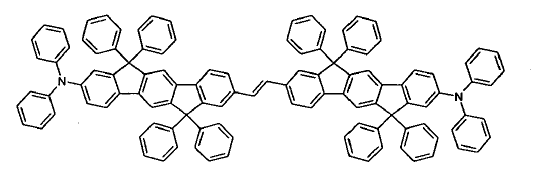 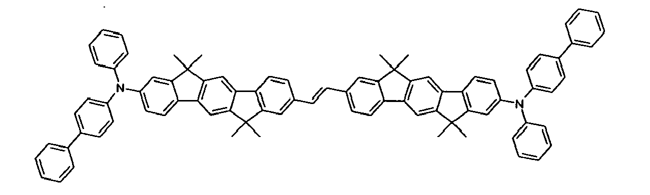 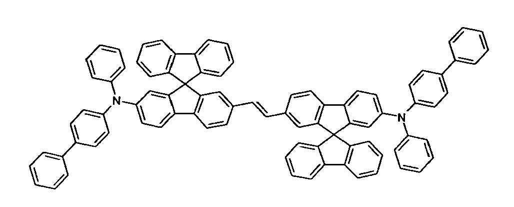 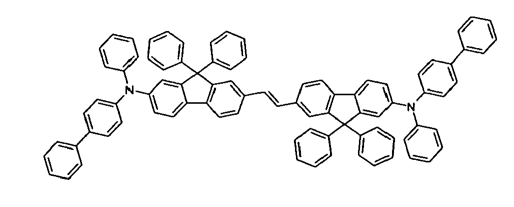 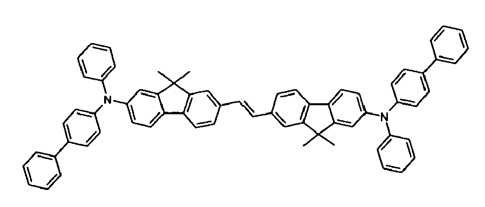 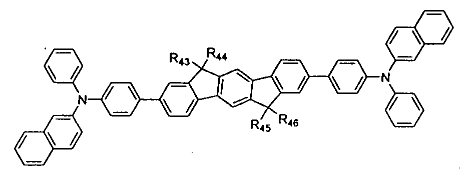 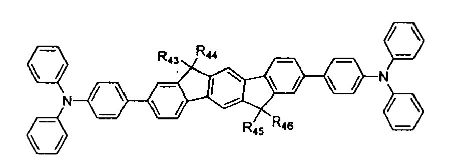 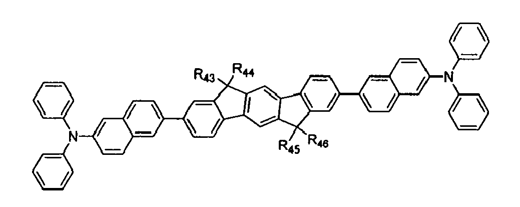 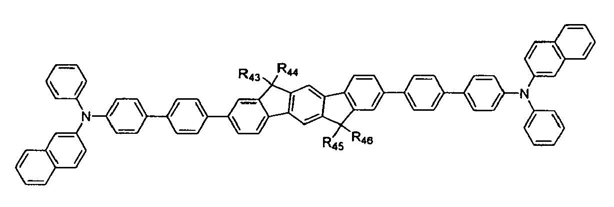 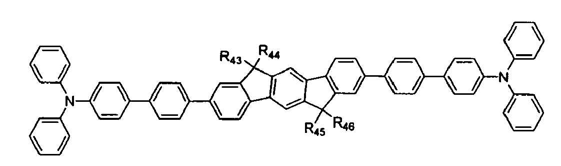 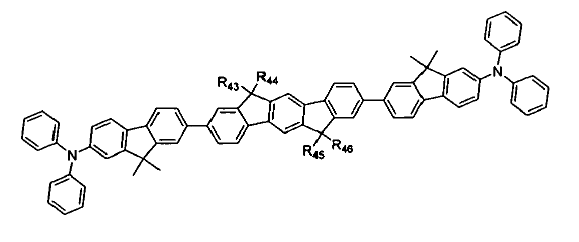 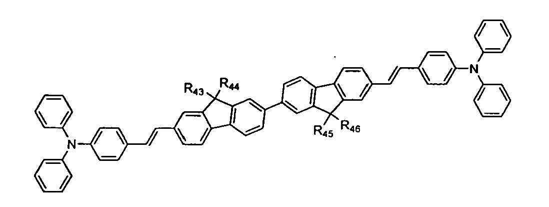 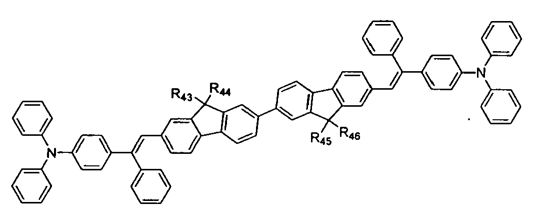 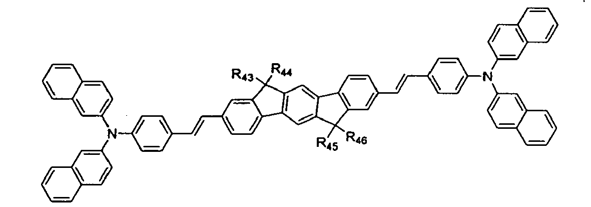 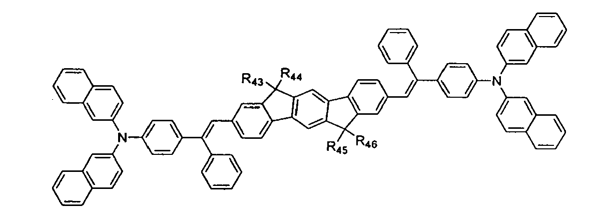 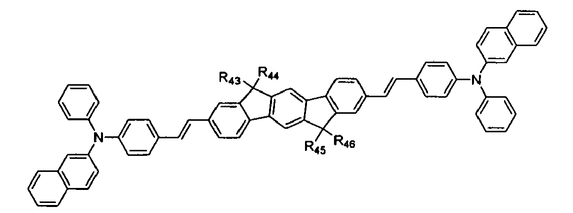 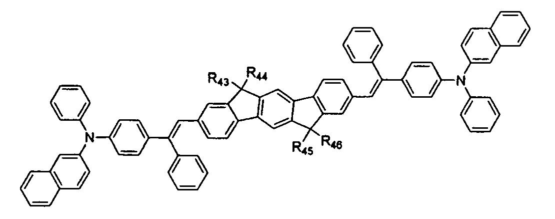 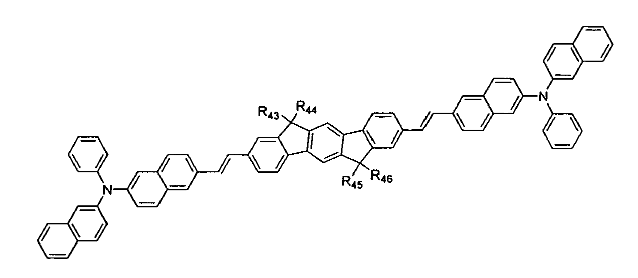 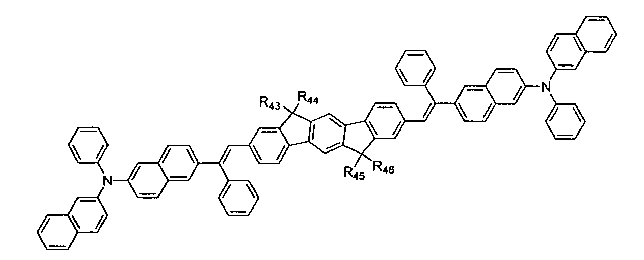 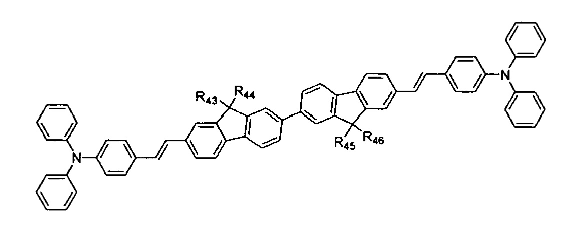 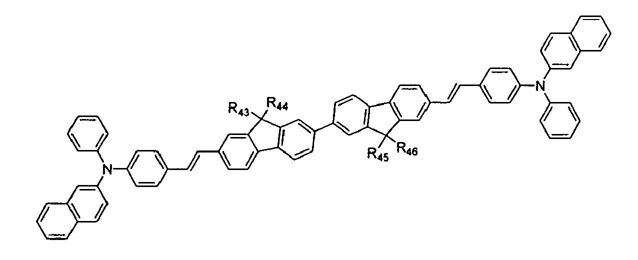 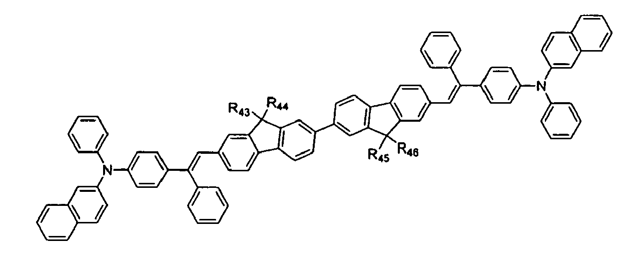 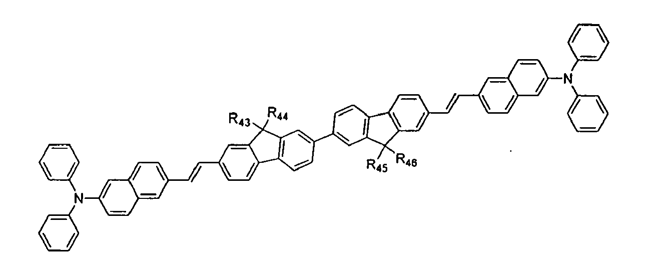 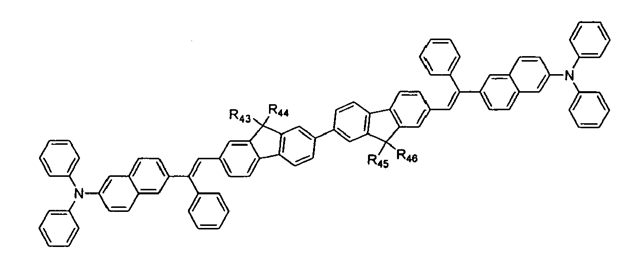 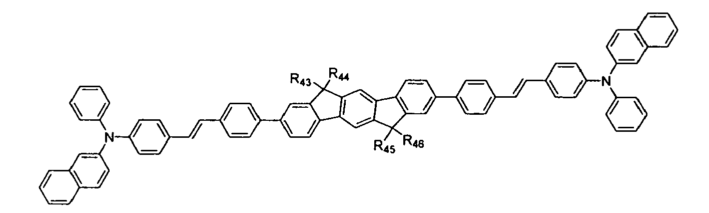 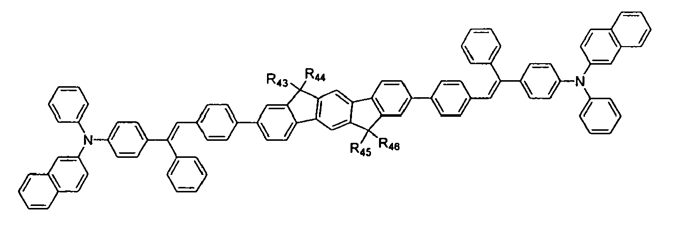 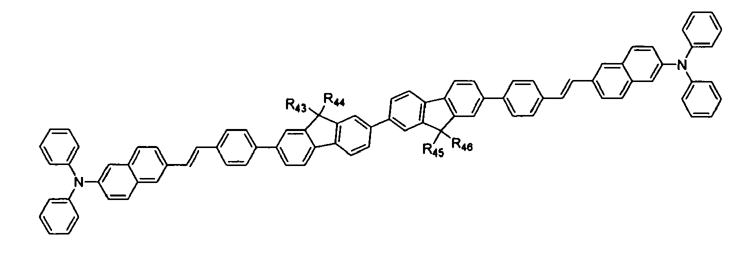 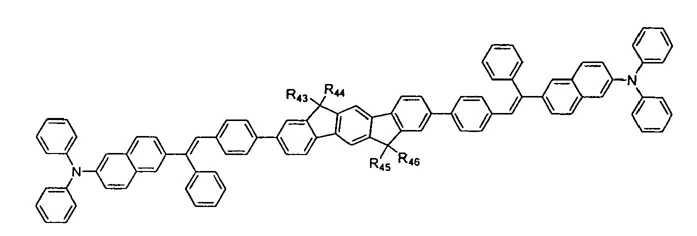 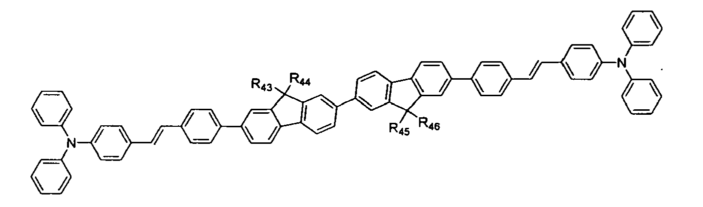 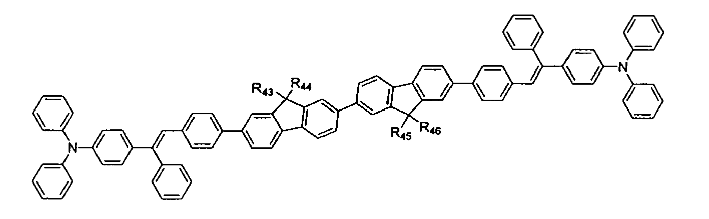 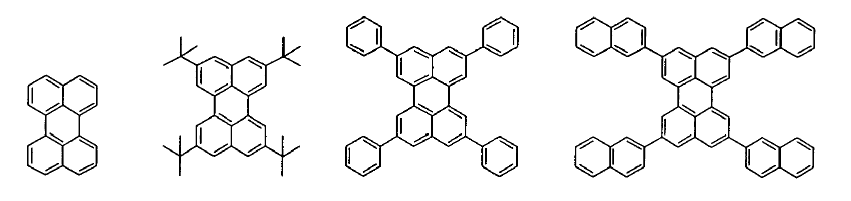 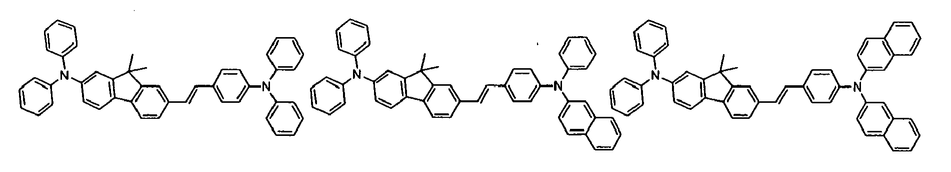 wherein, R₄₃ through R₄₆ represents methyl group or ethyl group.

Green electroluminescent dopants can be exemplified by the compounds represented by Chemical Formula (5) or (6).

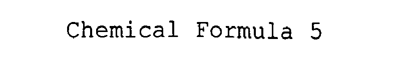

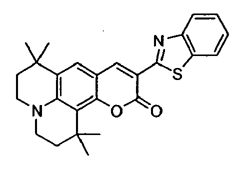

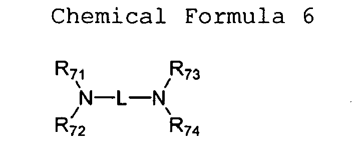

In Chemical Formula (6),
L represents (C6-C60)arylene with or without one or more substituent(s) selected from a group consisting of hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; and the alkyl, cycloalkyl, heterocycloalkyl, aryl, heteroaryl, arylsilyl, aryloxy, alkyloxy, arylthio, alkylthio, alkylsilyl, alkylamino and arylamino substituent on the arylene may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(Cl-C60)alkyl, (C6-C60)aryloxy, (C6-C60)arylthio, (C1-C60)alkoxycarbonyl, carboxyl, nitro and hydroxyl;
R₇₁ through R₇₄ independently represent hydrogen, halogen, deuterium, (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, adamantyl, (C3-C60)cycloalkyl, or each of R₇₁ through R₇₄ may be linked to an adjacent substituent via (C3-C60)alkylene or (C3-C60)alkenylene with or without a fused ring to form an alicyclic ring, or a monocyclic or polycyclic aromatic ring; and
the alkyl, aryl, heteroaryl, arylamino, alkylamino, cycloalkyl and heterocycloalkyl of R₇₁ through R₇₄ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

The compounds of Chemical Formula (6) can be exemplified by the following compounds.

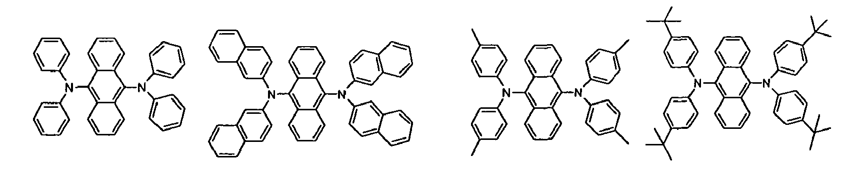

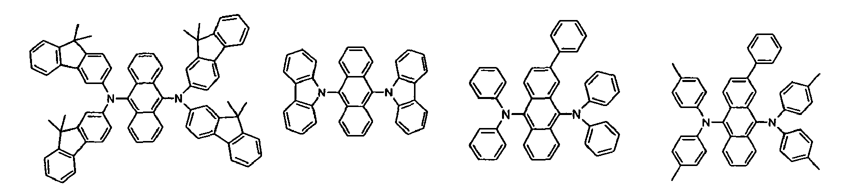

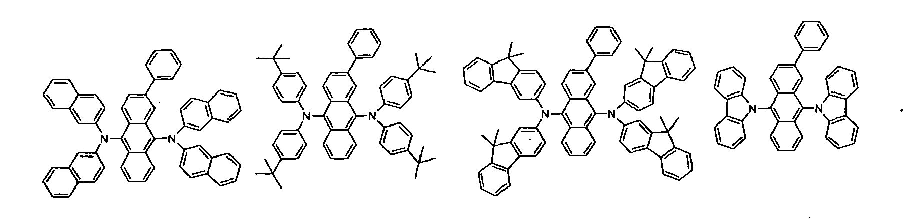

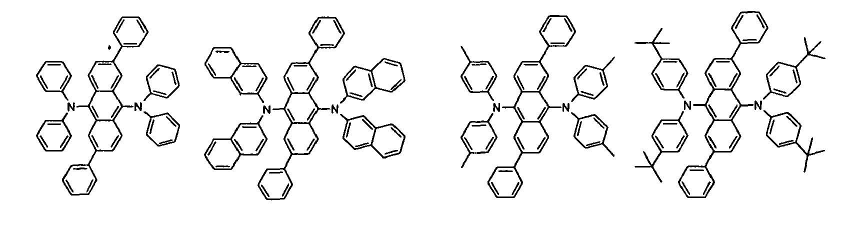

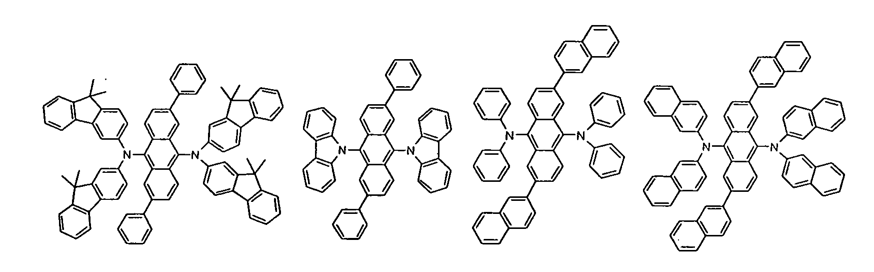

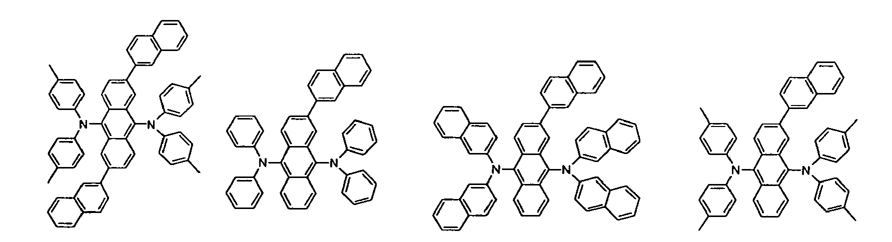

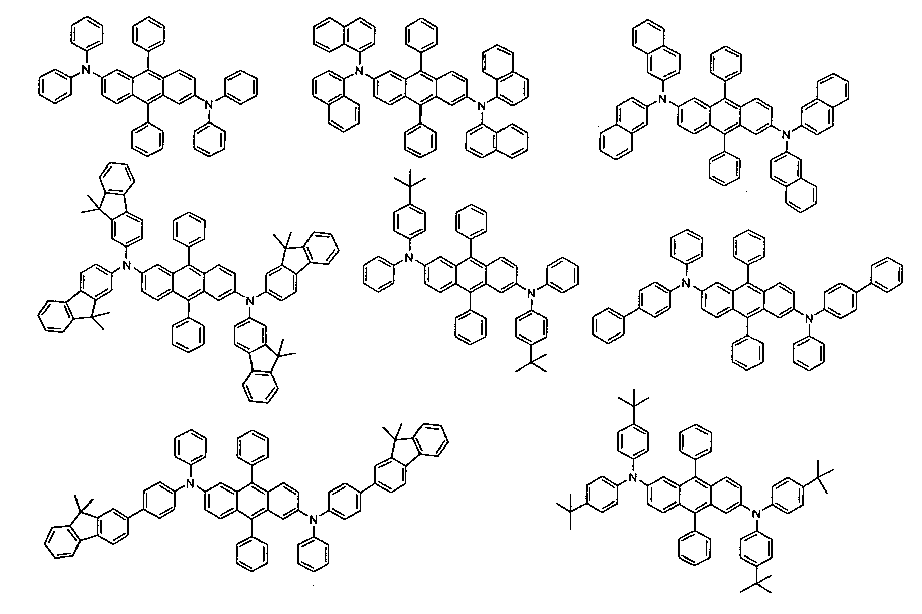

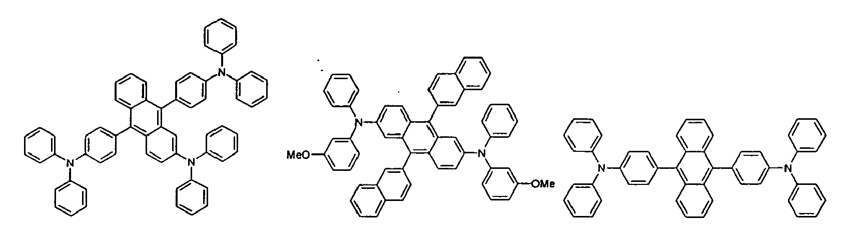

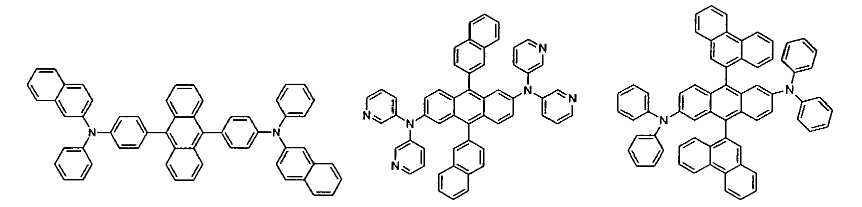

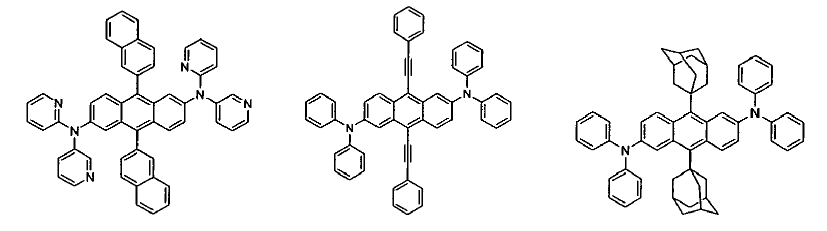

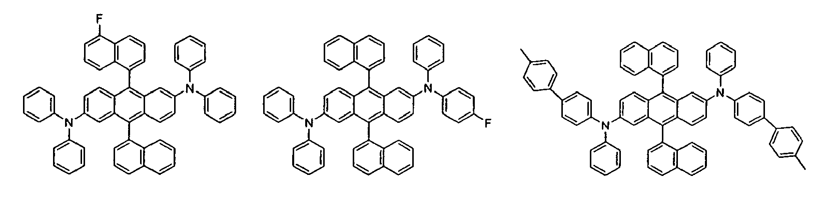

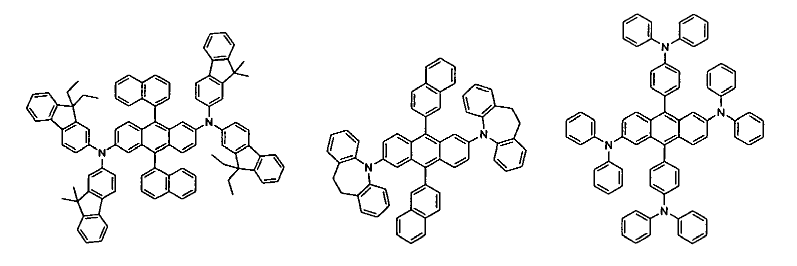

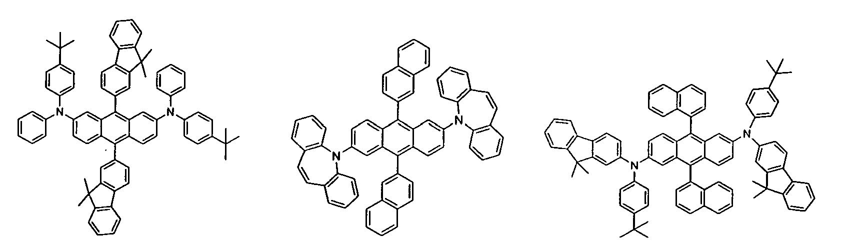

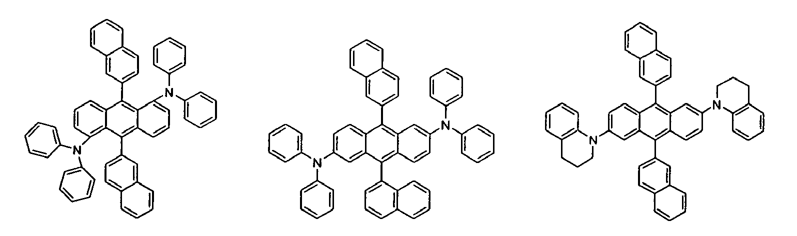

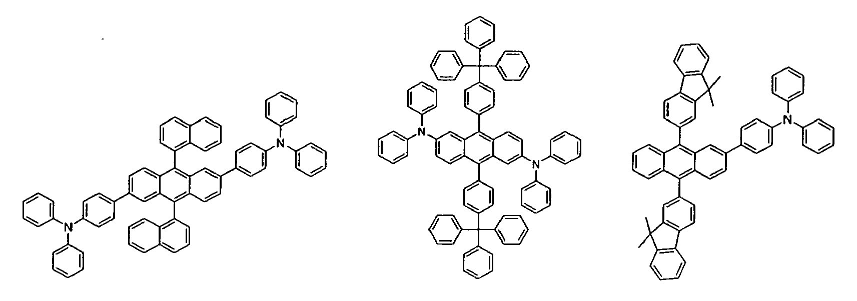

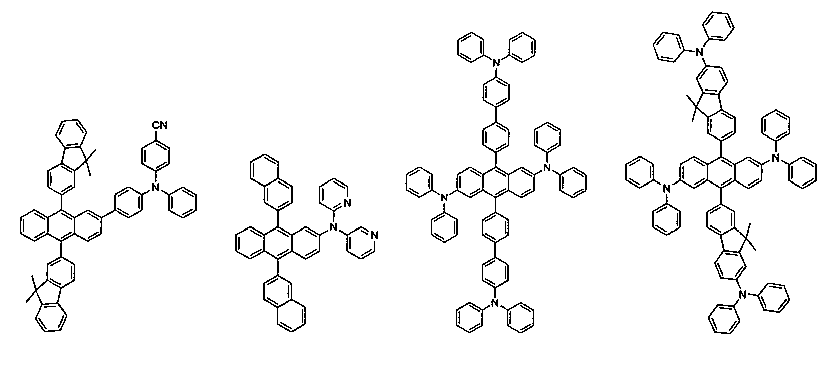

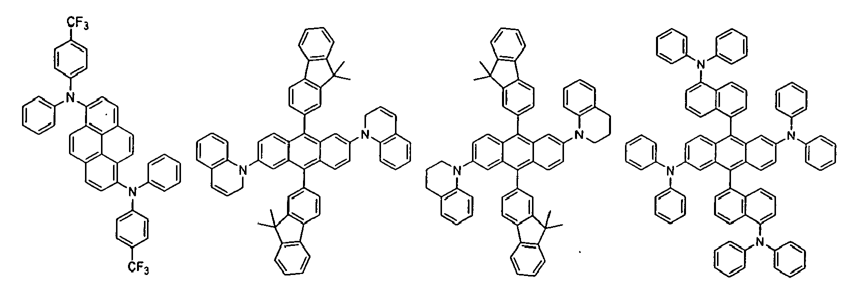

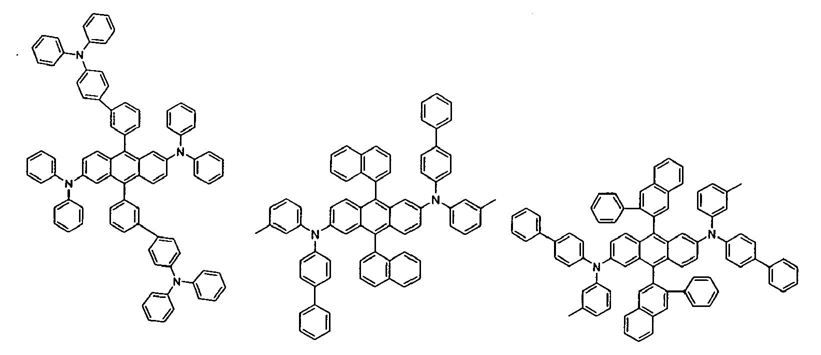

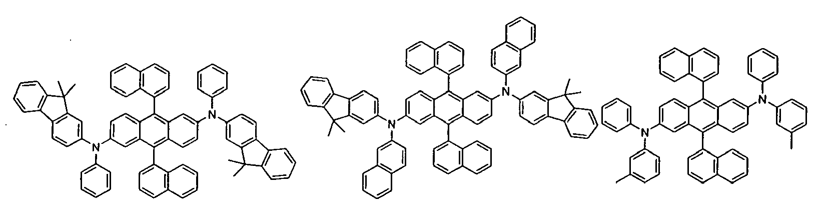

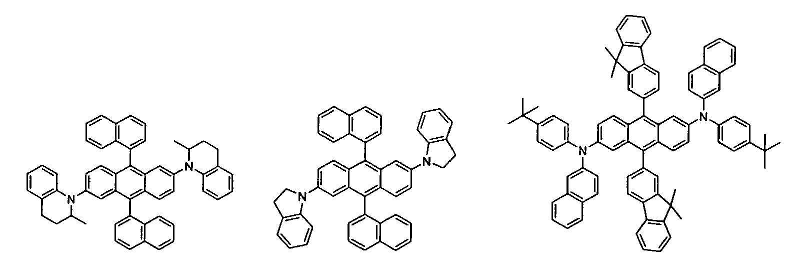

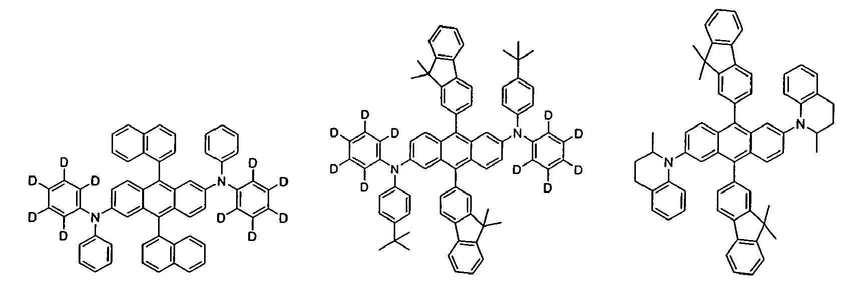

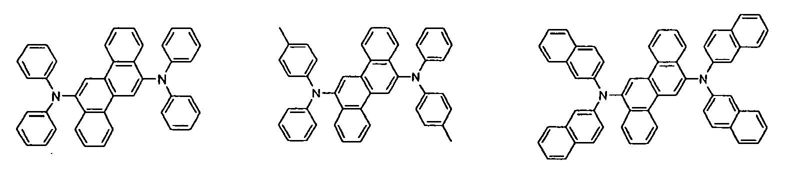

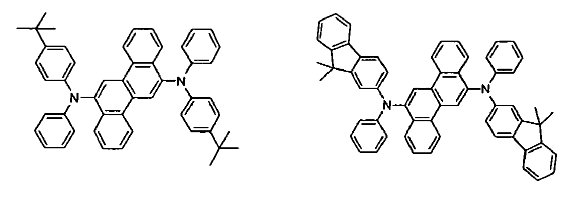

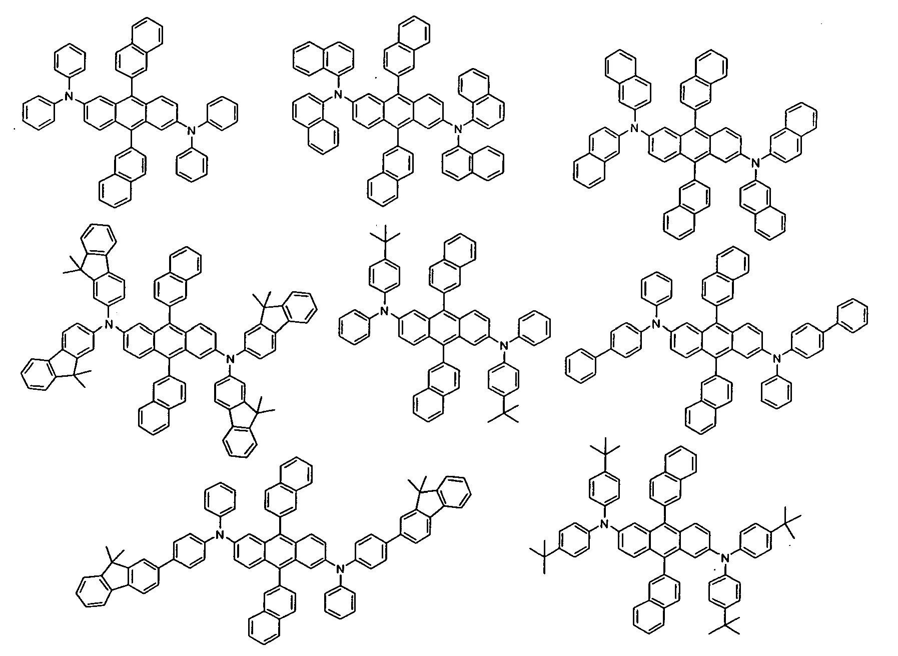

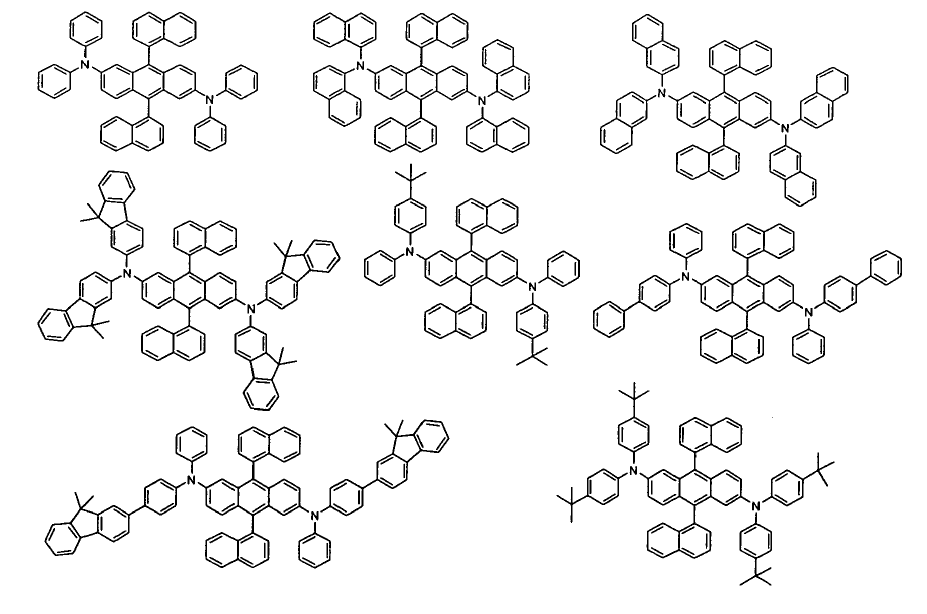

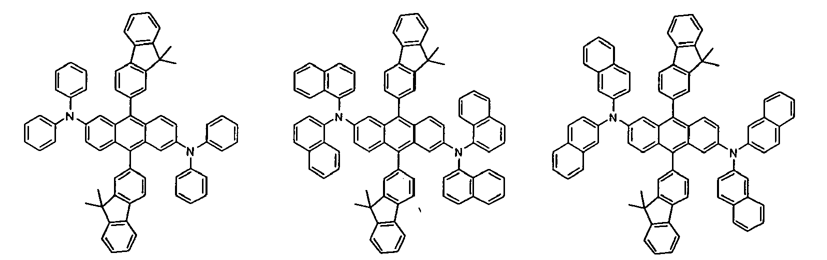

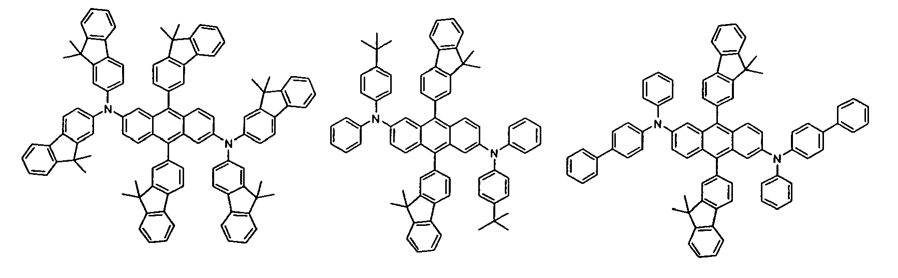

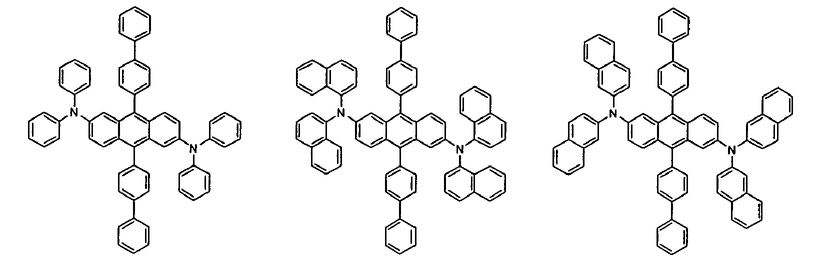

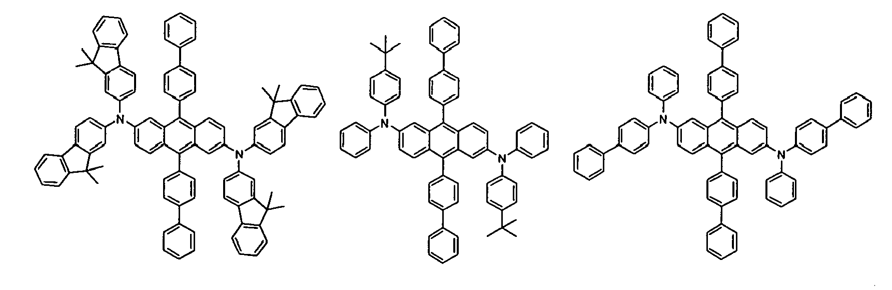

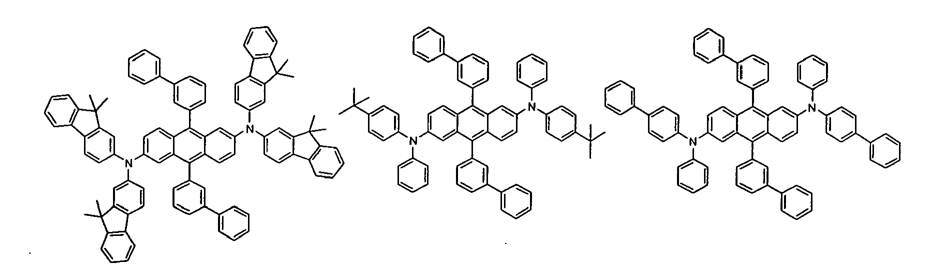

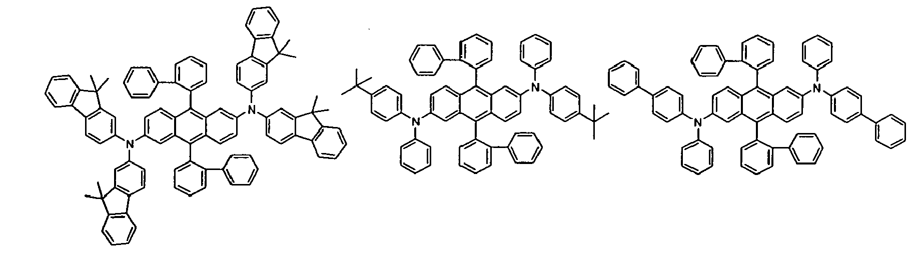

Red electroluminescent dopants can be exemplified by the compounds represented by Chemical Formula (7):

Chemical Formula 7 M¹L¹L²L³

wherein, M¹ is selected from a group consisting of metals from Group 7, 8, 9, 10, 11, 13, 14, 15 and 16 of the Periodic Table of Elements, preferably from Ir, Pt, Pd, Rh, Re, Os, T1, Pb, Bi, In, Sn, Sb, Te, Au and Ag. Ligands, L¹, L² and L³ are independently selected from the following structures: 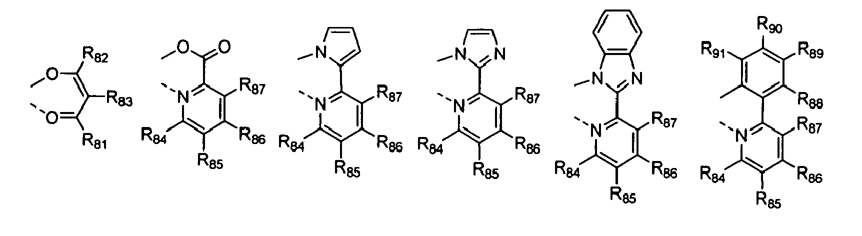 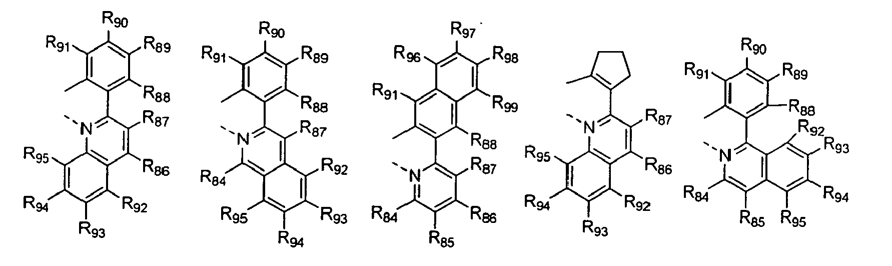 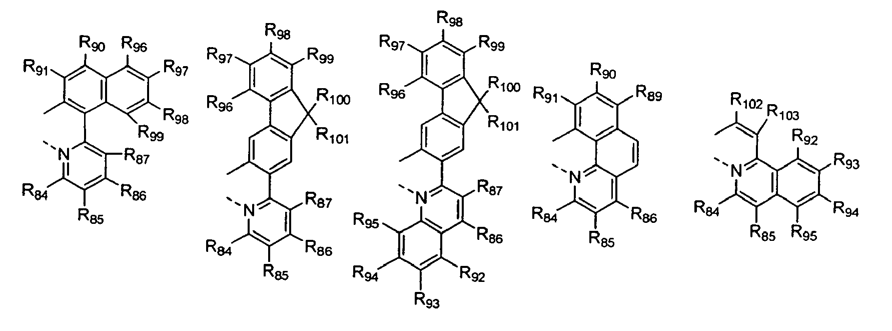 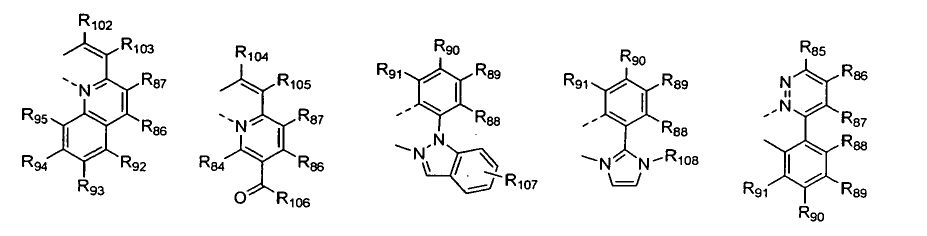 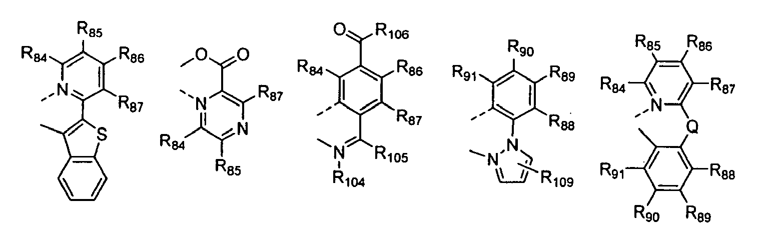 wherein, R₈₁ through R₈₃ independently represent hydrogen, deuterium, (C1-C60)alkyl with or without halogen substituent(s), (C6-C60)aryl with or without (C1-C60)alkyl substituent, or halogen;
R₈₄ through R₉₉ independently represent hydrogen, deuterium, (C1-C60)alkyl, (Cl-C30)alkoxy, (C3-C60)cycloalkyl, (C2-C30)alkenyl, (C6-C60)aryl, mono or di(C1-C30)alkylamino, mono or di(C6-C30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₈₄ through R₉₉ may be further substituted by one or more substituent(s) selected from deuterium, (C1-C60)alkyl, (C6-C60)aryl and halogen;
R₁₀₀ through R₁₀₃ independently represent hydrogen, deuterium, (C1-C60)alkyl with or without halogen substituent(s), or (C6-C60)aryl with or without (C1-C60)alkyl substituent;
R₁₀₄ and R₁₀₅ independently represent hydrogen, deuterium, (C1-C60)alkyl, (C6-C60)aryl or halogen, or R₁₀₄ and R₁₀₅ may be linked via (C3-C12)alkylene or (C3-C12)alkenylene with or without a fused ring to form an alicyclic ring, or a monocyclic or polycyclic aromatic ring; and the alkyl or aryl of R₁₀₄ and R₁₀₅, or the alicyclic ring, or the monocyclic or polycyclic aromatic ring formed therefrom by linkage via (C3-C12)alkylene or (C3-C12)alkenylene with or without a fused ring may be further substituted by one or more substituent(s) selected from deuterium, (C1-C60)alkyl with or without halogen substituent(s), (C1-C30)alkoxy, halogen, tri(C1-C30)alkylsilyl, tri(C6-C30)arylsilyl and (C6-C60)aryl;
R₁₀₆ represents (C1-C60)alkyl, (C6-C60)aryl, (C5-C60)heteroaryl or halogen;
R₁₀₇ through R₁₀₉ independently represent hydrogen, deuterium, (C1-C60)alkyl, (C6-C60)aryl or halogen, and the alkyl or aryl of R₁₀₆ through R₁₀₉ may be further substituted by halogen or (C1-C60)alkyl; and
Q represents 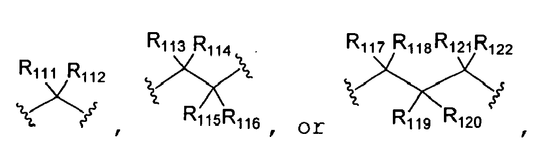 wherein R₁₁₁ through R₁₂₂ independently represent hydrogen, deuterium, (Cl-C60)alkyl with or without halogen substituent(s), (C1-C30)alkoxy, halogen, (C6-C60)aryl, cyano or (C5-C60)cycloalkyl, or each of R₁₁₁ through R₁₂₂ may be linked to an adjacent substituent via alkylene or alkenylene to form a (C5-C7)spiro ring or a (C5-C9) fused ring, or may be linked with R₈₇ or R₈₈ via alkylene or alkenylene to form a (C5-C7)fused ring.

The compounds of Chemical Formula (7) can be specifically exemplified by the following compounds, but are not restricted thereto.

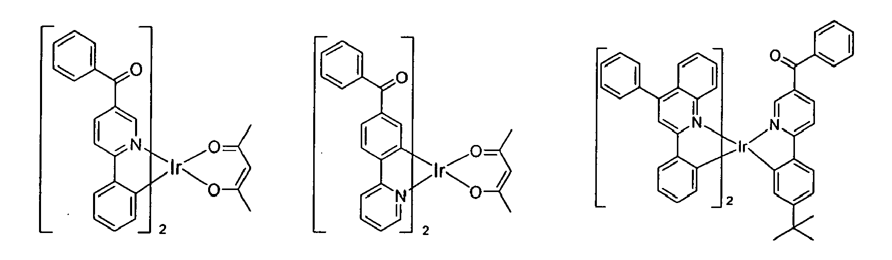

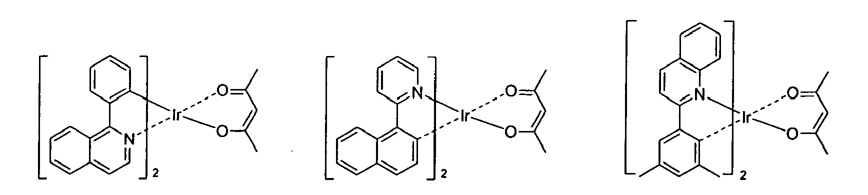

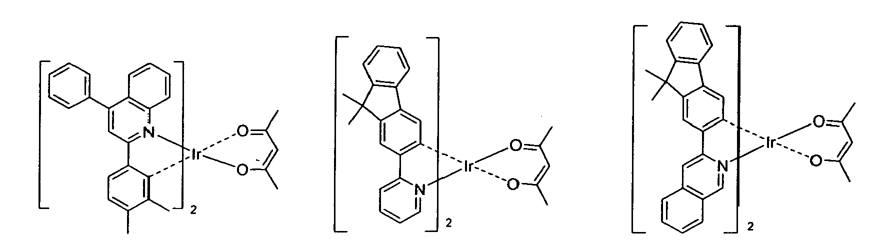

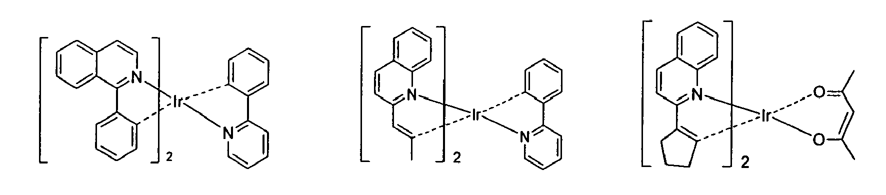

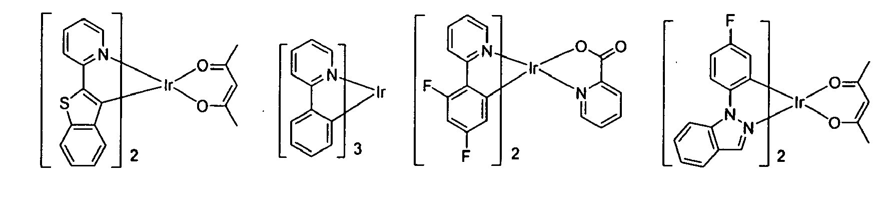

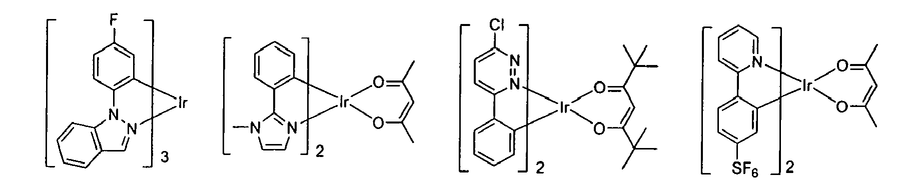

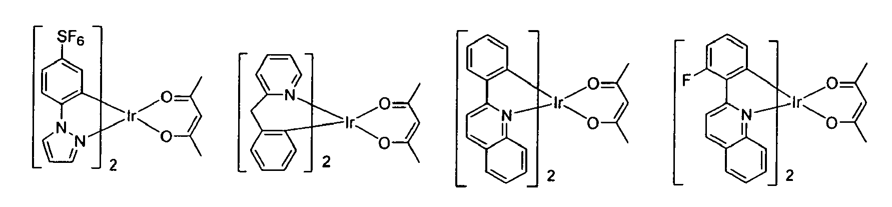

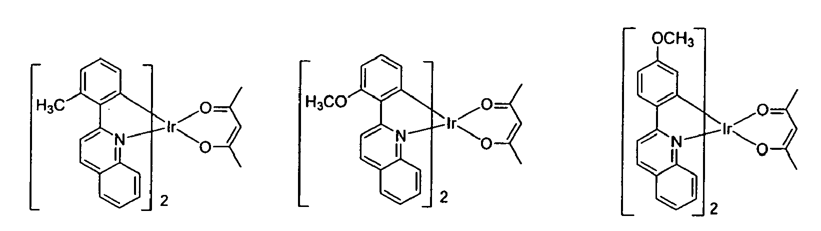

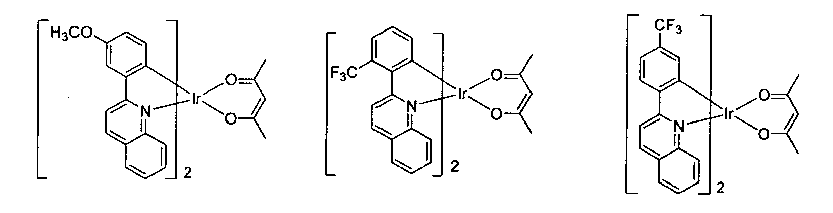

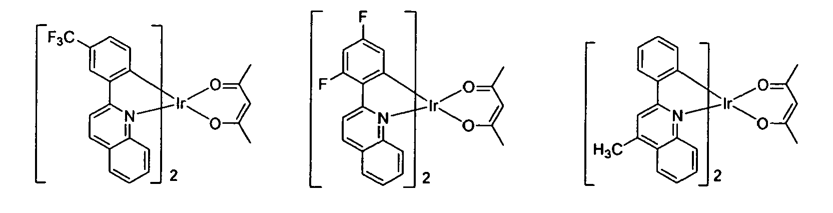

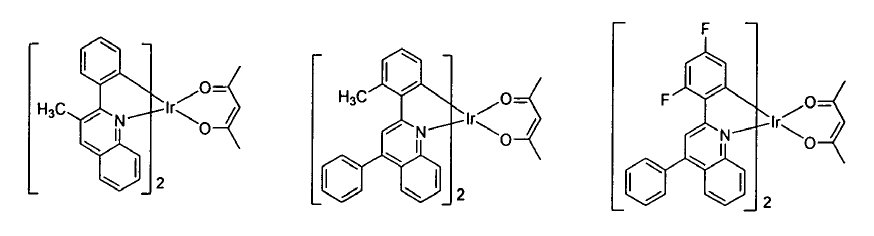

The electroluminescent layer means the layer where electroluminescence takes place, and it may be a single layer or a multi-layer consisting of two or more layers laminated. When a mixture of host-dopant is used according to the construction of the present invention, noticeable improvement in luminous efficiency could be confirmed.

The organic light emitting diode according to the invention may further comprise one or more compound(s) selected from arylamine compounds and styrylarylamine compounds, as well as the organic electroluminescent compound represented by Chemical Formula (1). Examples of the arylamine or styrylarylamine compounds include the compounds represented by Chemical Formula (8), but they are not restricted thereto: 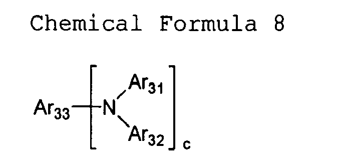 wherein, Ar₃₁ and Ar₃₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₃₁ and Ar₃₂ may be linked via (C3-C60)alkylene or (C3-C60)alkenylene with or without a fused ring to form an alicyclic ring, or a monocyclic or polycyclic aromatic ring;
when c is 1, Ar₃₃ represents (C6-C60) aryl, (C4-C60)heteroaryl, or a substituent represented by one of the following structural formulas: 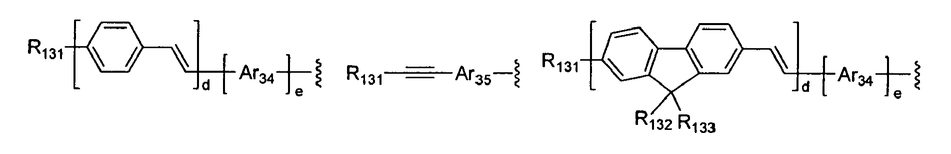 when c is 2, Ar₃₃ represents (C6-C60)arylene, (C4-C60)heteroarylene, or a substituent represented by one of the following structural formulas: 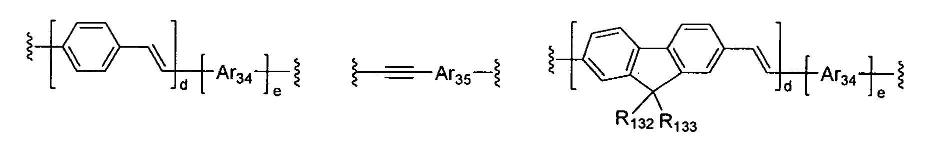 wherein Ar₃₄ and Ar₃₅ independently represent (C6-C60)arylene or (C4-C60)heteroarylene;
R₁₃₁ through R₁₃₃ independently represent hydrogen, deuterium, (C1-C60)alkyl or (C6-C60)aryl;
d is an integer from 1 to 4, e is an integer of 0 or 1; and
the alkyl, aryl, heteroaryl, arylamino, alkylamino, cycloalkyl or heterocycloalkyl of Ar₃₁ and Ar₃₂, or the aryl, heteroaryl, arylene or heteroarylene of Ar₃₃, or the arylene or heteroarylene of Ar₃₄ and Ar₃₅, or the alkyl or aryl of R₁₃₁ through R₁₃₃ may be further substituted by one or more substituent(s) selected from a group consisting of deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

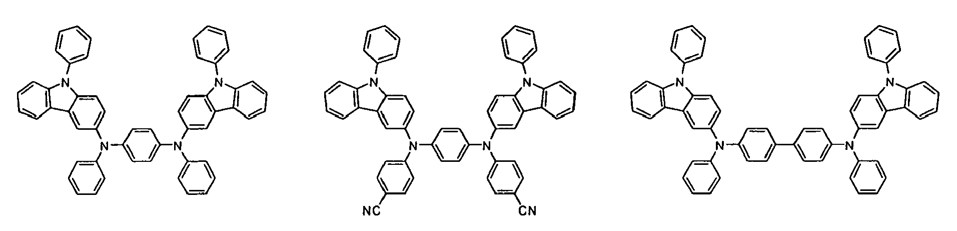

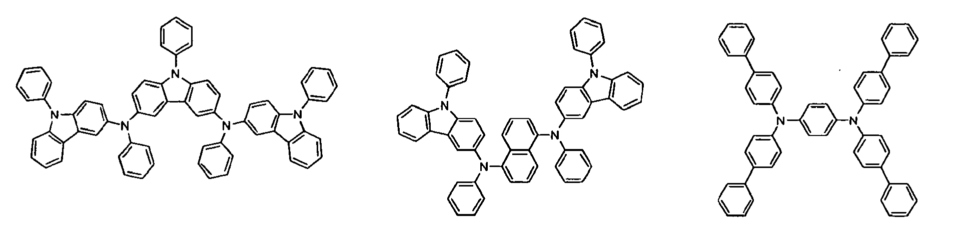

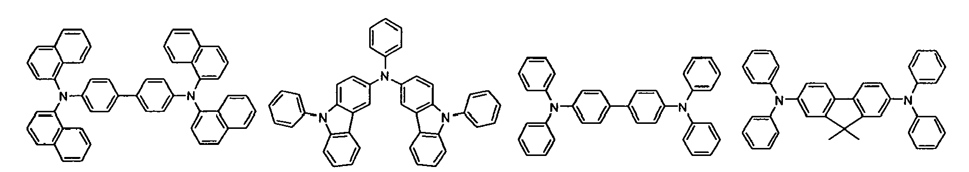

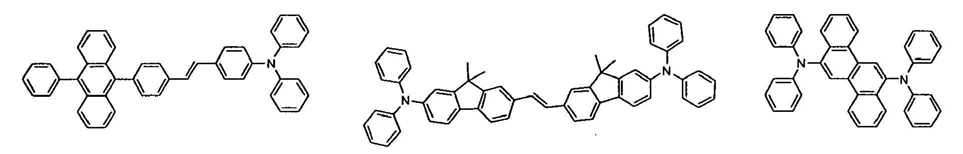

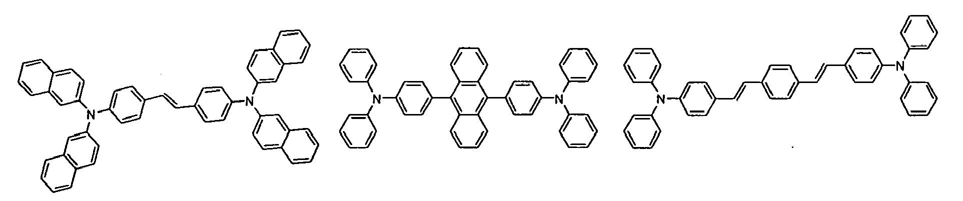

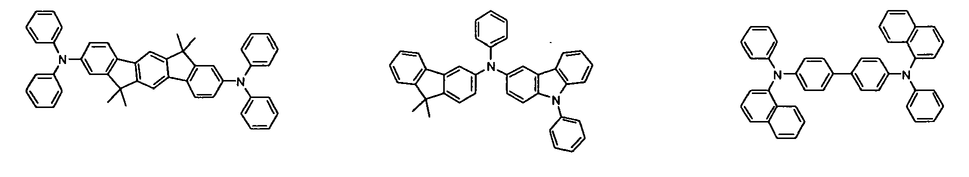

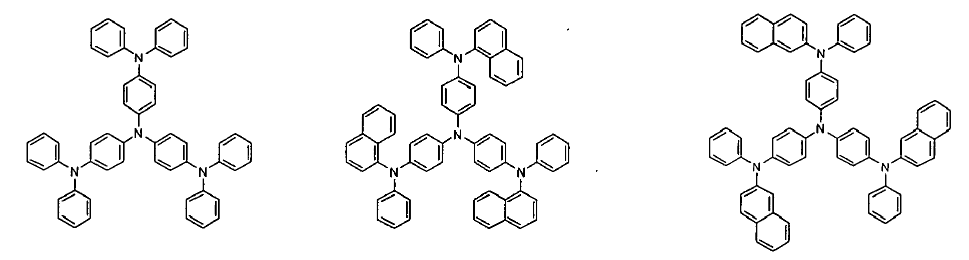

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements, as well as the organic electroluminescent compound represented by Chemical Formula (1). The organic layer may comprise an electroluminescent layer and a charge generating layer at the same time.

In an organic light emitting diode according to the present invention, it is preferable to displace one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metal or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the present invention is advantageous in that they can be employed to manufacture OLED's having excellent luminous efficiency, good color purity, and lowered operation voltage. The organic compounds according to the invention can be advantageous applied to either fluorescent devices or phosphorescent devices.

### Best Mode

The present invention is further described by referring to representative compounds with regard to the organic electroluminescent compounds according to the invention, preparation thereof and luminous properties of the devices manufactured therefrom, but those examples are provided for better understanding of the present invention only but are not intended to limit the scope of the invention by any means.

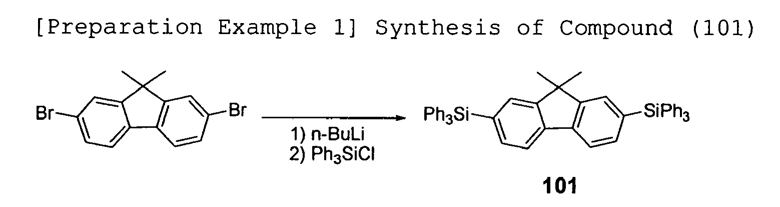

A 500 mL round bottomed flask was charged with 2,7-dibromo-(9,9'-dimethyl)flurene (10.0 g, 28.4 mmol) and THF (200 mL), and n-BuLi (1.6 M in THF) (28.4 ml, 71.0 mmol) was added dropwise at -78°C. After stirring the mixture for 1 hour, triphenylsilylchloride (Ph₃SiCl) (20.9 g, 71.0 mmol) was added dropwise thereto, and the temperature was raised to ambient temperature, and the reaction mixture was stirred for 12 hours. When the reaction was completed, distilled water was added to the reaction mixture, which was then extracted with organic solvent. The extract was purified via silica gel column chromatography to obtain the title compound (101) (6.74 g, 9.49 mmol, yield 33.4%).
mp 254 °C
¹H NMR(300 MHz, CDCl₃) : δ = 7.93 (m, 2H), 7.84 (m, 2H), 7.66 (m, 2H), 7.46 (m, 12H), 7.37 (m, 18H), 1.67 (s, 6H).
HRMS(FAB) found. 710.2832 (C₅₁H₄₂Si₂ calc. 710.2825)

According to the same procedure as Preparation Example 1, the compounds listed in Table 1 were prepared, of which the ¹H NMR data are listed in Table 2.

**Table 1**

| | | | | | |
|---|---|---|---|---|---|
| 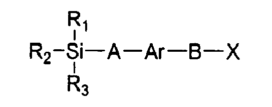 | | | | | |

| Comp. | R₁ | R₂ | R₃ | 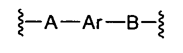 | 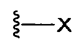 |
|---|---|---|---|---|---|
| 102 | 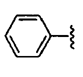 | 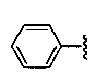 | 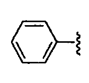 | 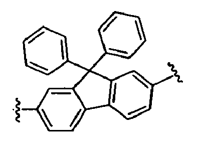 | 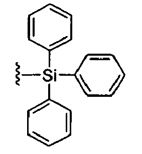 |
| 103 | 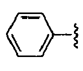 | 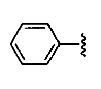 | 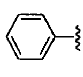 | 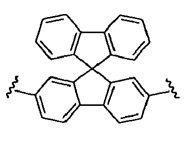 | 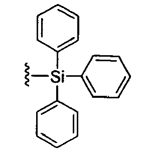 |
| 104 | 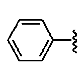 | 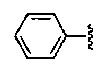 | 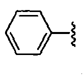 | 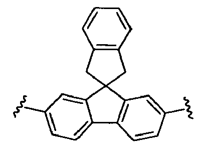 | 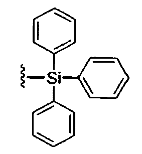 |
| 105 | 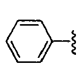 | 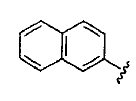 | 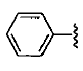 | 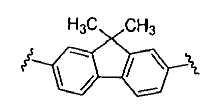 | 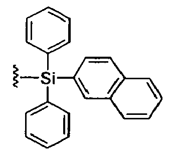 |
| 106 | 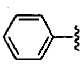 | 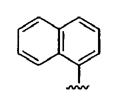 | 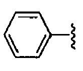 | 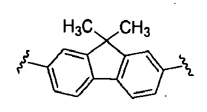 | 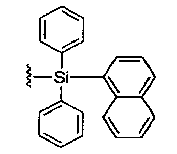 |
| 107 | 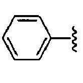 | 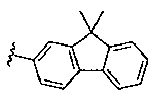 | 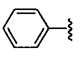 | 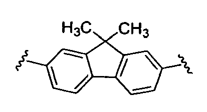 | 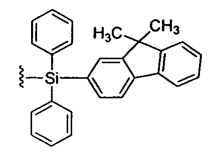 |
| 108 | 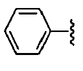 | 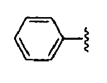 | 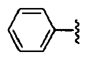 | 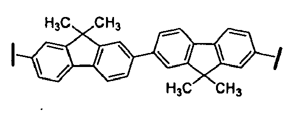 | 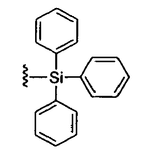 |
| 109 | 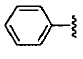 | 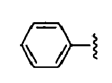 | 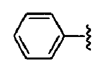 | 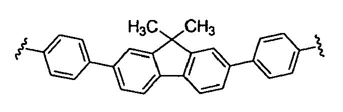 | 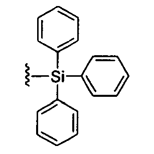 |
| 110 | 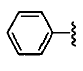 | 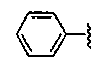 | 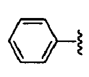 | 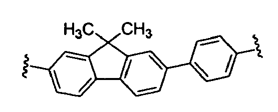 | 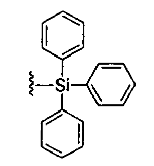 |
| 111 | 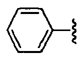 | 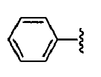 | 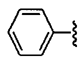 | 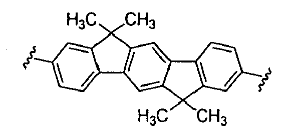 | 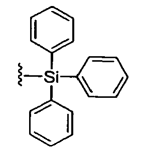 |
| 112 | 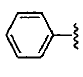 | 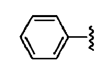 | 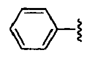 | 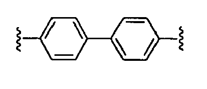 | 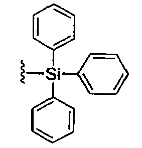 |
| 113 | 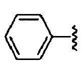 | 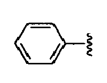 | 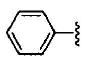 | 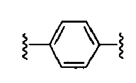 | 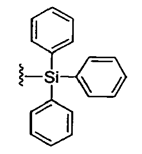 |
| 114 | 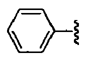 | 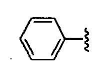 | 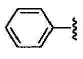 | 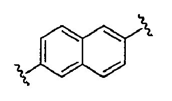 | 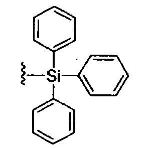 |
| 115 | 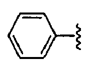 | 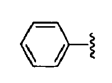 | 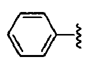 | 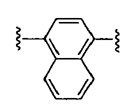 | 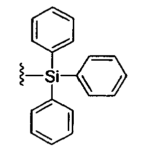 |
| 116 | 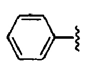 | 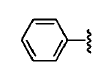 | 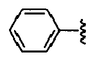 | 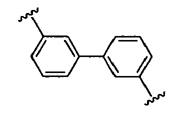 | 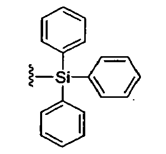 |
| 117 | 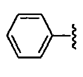 | 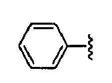 | 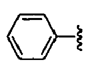 | 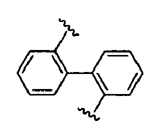 | 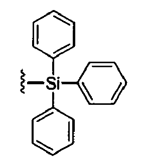 |
| 118 | 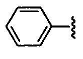 | 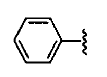 | 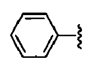 | 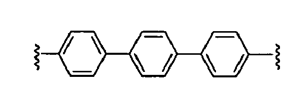 | 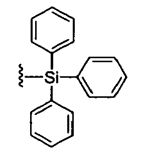 |
| 119 | 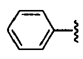 | 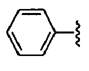 | 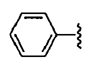 | 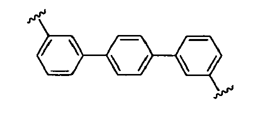 | 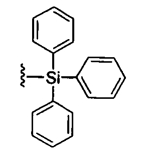 |
| 120 | 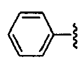 | 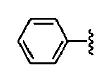 | 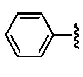 | 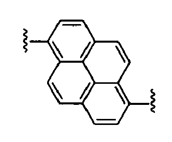 | 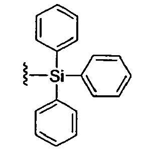 |
| 121 | 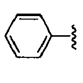 | 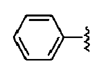 | 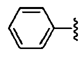 | 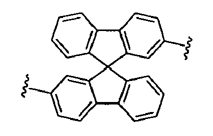 | 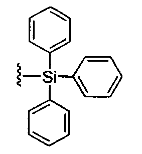 |
| 122 | 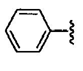 | 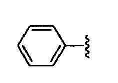 | 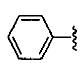 | 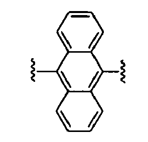 | 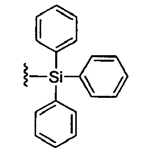 |
| 123 | 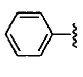 | 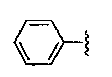 | 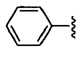 | 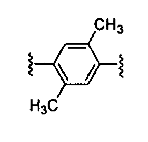 | 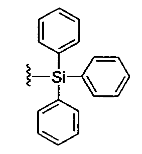 |
| 124 | 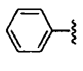 | 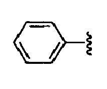 | 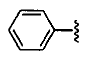 | 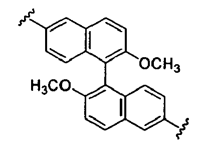 | 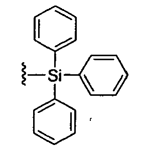 |
| 125 | 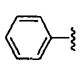 | 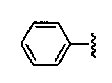 | 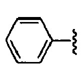 | 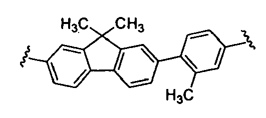 | 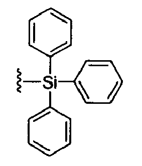 |
| 126 | 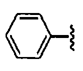 | 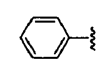 | 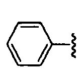 | 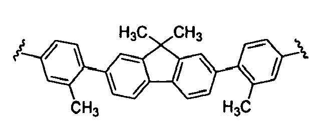 | 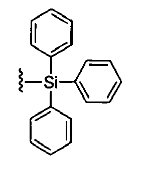 |
| 127 | 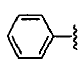 | 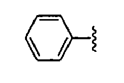 | 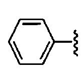 | 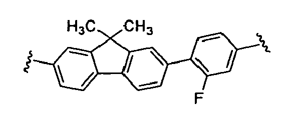 | 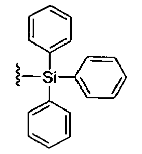 |
| 128 | 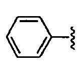 | 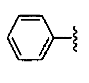 | 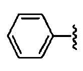 | 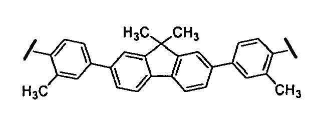 | 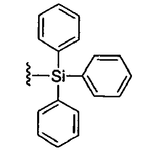 |
| 129 | 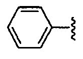 | 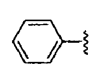 | 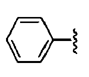 | 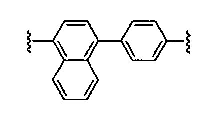 | 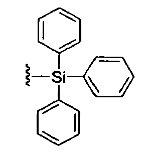 |
| 130 | 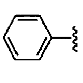 | 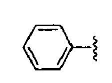 | 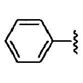 | 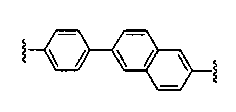 | 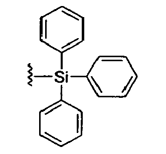 |
| 131 | 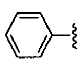 | 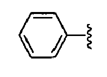 | 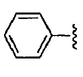 | 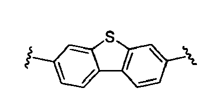 | 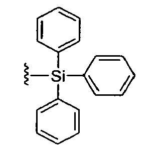 |
| 132 | 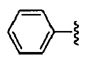 | 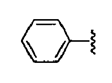 | 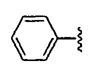 | 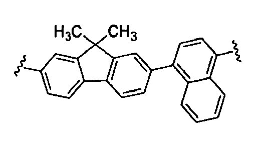 | 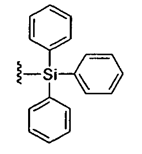 |
| 133 | 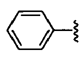 | 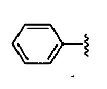 | 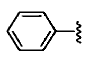 | 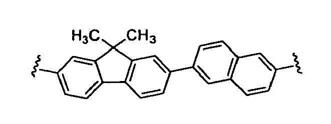 | 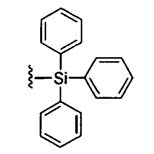 |
| 134 | 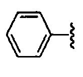 | 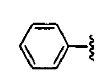 | 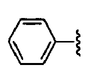 | 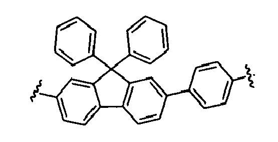 | 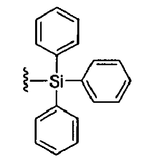 |
| 135 | 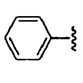 | 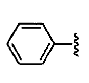 | 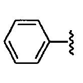 | 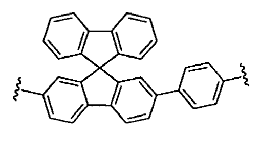 | 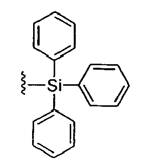 |
| 136 | 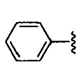 | 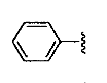 | 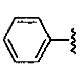 | 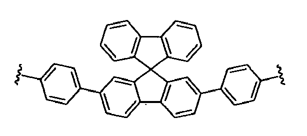 | 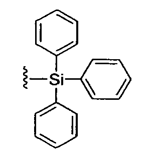 |
| 137 | 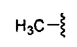 | 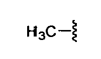 | 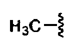 | 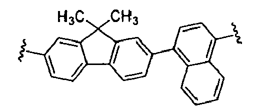 | 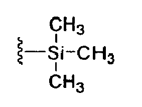 |
| 138 | 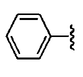 | 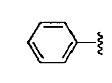 | 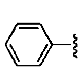 | 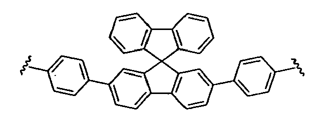 | 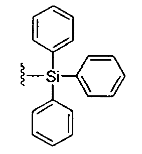 |
| 139 | 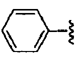 | 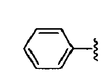 | 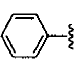 | 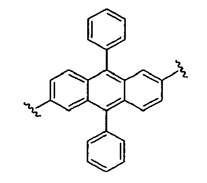 | 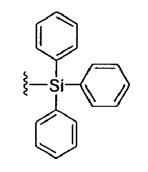 |
| 140 | 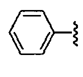 | 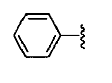 | 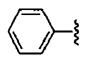 | 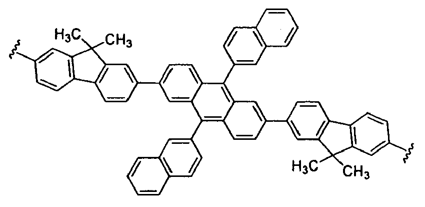 | 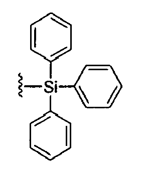 |
| 141 | 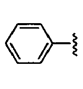 | 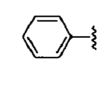 | 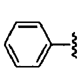 | 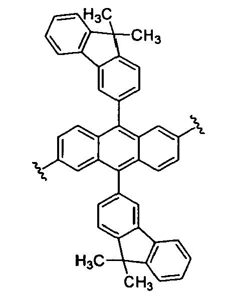 | 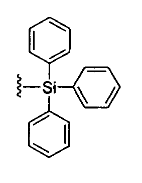 |
| 142 | 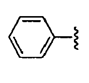 | 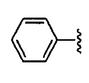 | 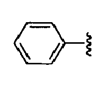 | 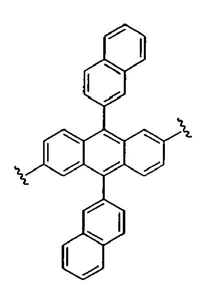 | 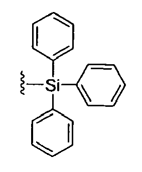 |
| 143 | 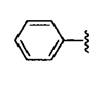 | 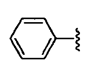 | 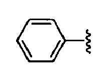 | 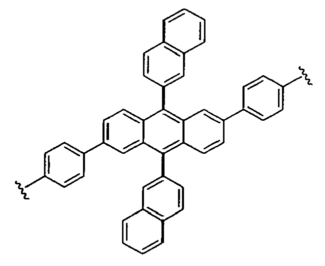 | 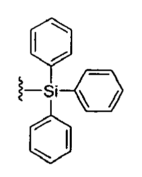 |
| 144 | 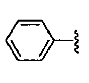 | 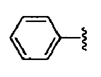 | 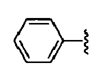 | 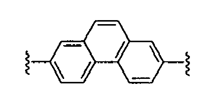 | 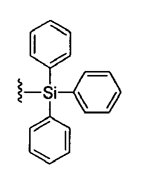 |
| 145 | 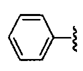 | 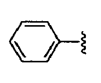 | 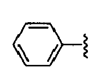 | 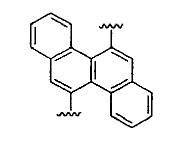 | 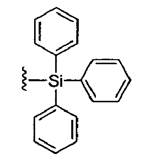 |
| 146 | 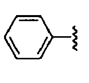 | 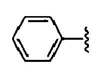 | 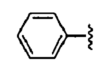 | 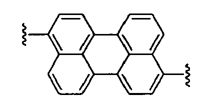 | 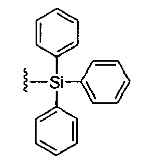 |
| 147 | 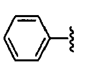 | 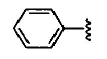 | 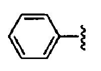 | 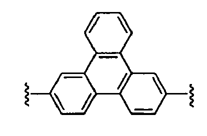 | 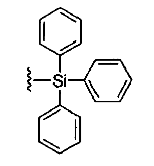 |
| 148 | 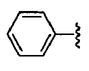 | 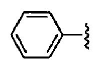 | 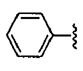 | 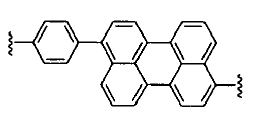 | 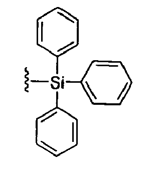 |
| 149 | 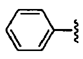 | 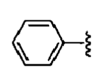 | 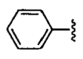 | 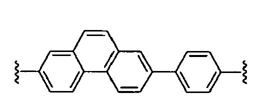 | 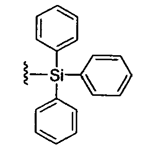 |
| 150 | 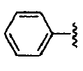 | 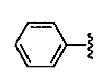 | 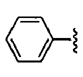 | 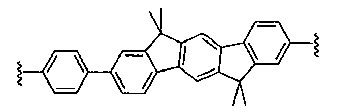 | 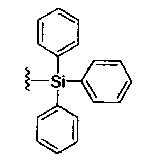 |
| 151 | 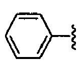 | 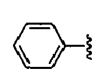 | 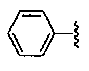 | 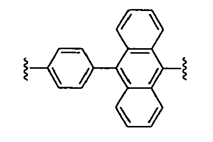 | 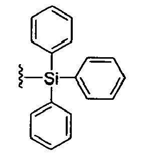 |
| 152 | 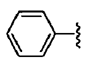 | 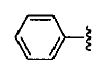 | 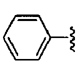 | 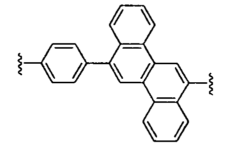 | 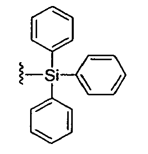 |
| 153 | 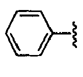 | 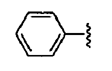 | 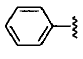 | 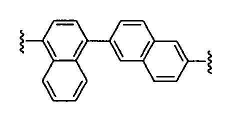 | 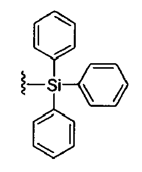 |
| 154 | 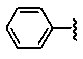 | 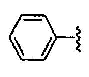 | 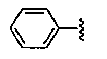 | 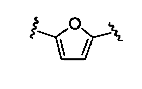 | 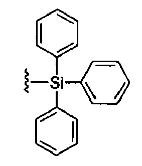 |
| 155 | 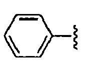 | 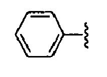 | 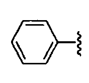 | 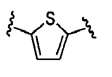 | 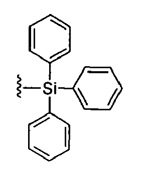 |
| 156 | 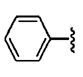 | 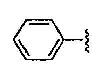 | 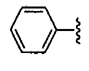 | 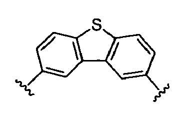 | 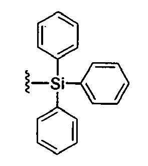 |
| 157 | 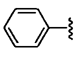 | 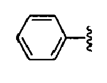 | 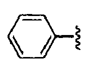 | 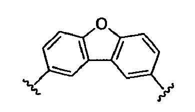 | 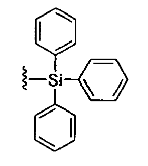 |
| 158 | 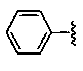 | 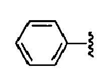 | 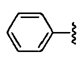 | 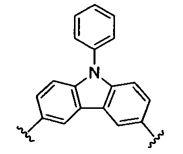 | 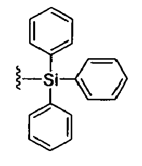 |
| 159 | 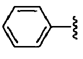 | 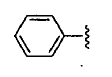 | 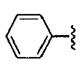 | 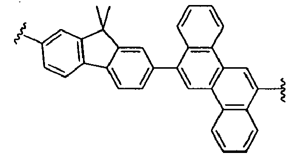 | 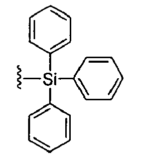 |
| 160 | 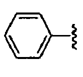 | 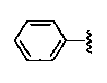 | 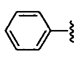 | 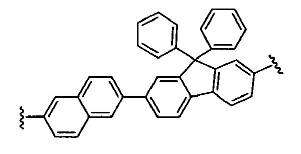 | 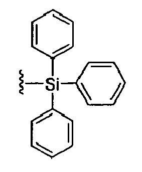 |
| 161 | 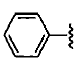 | 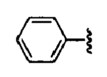 | 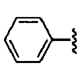 | 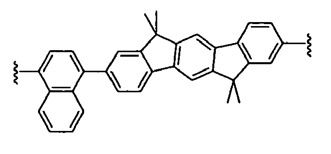 | 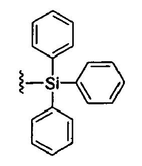 |
| 162 | 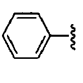 | 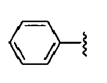 | 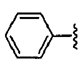 | 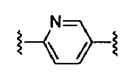 | 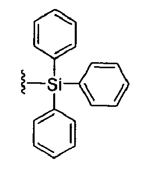 |
| 163 | 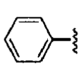 | 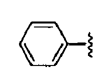 | 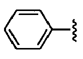 | 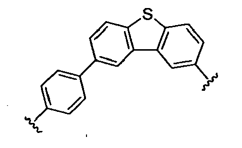 | 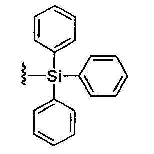 |
| 164 | 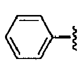 | 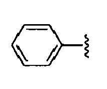 | 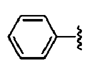 | 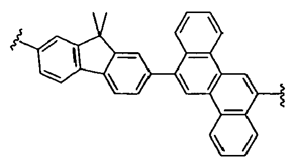 | 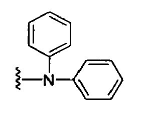 |
| 165 | 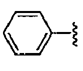 | 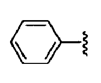 | 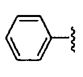 | 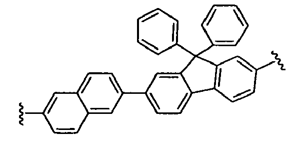 | 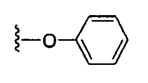 |
| 166 | 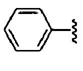 | 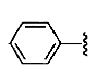 | 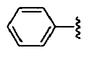 | 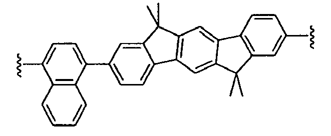 | 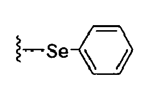 |
| 167 | 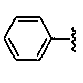 | 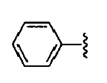 | 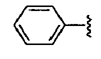 | 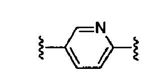 | 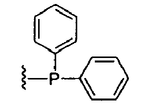 |
| 168 | 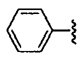 | 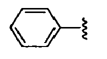 | 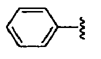 | 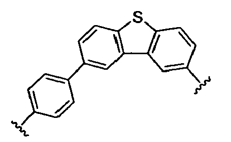 | 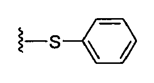 |
| 169 | 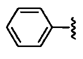 | 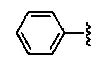 | 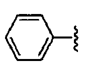 | 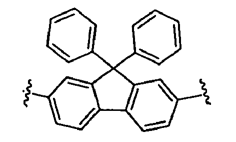 | 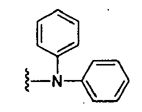 |
| 170 | 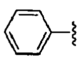 | 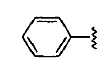 | 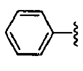 | 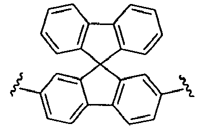 | 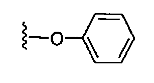 |
| 171 | 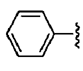 | 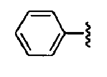 | 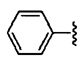 | 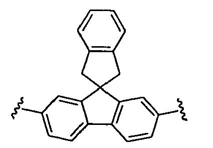 | 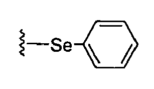 |
| 172 | 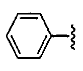 | 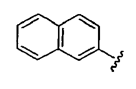 | 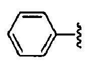 | 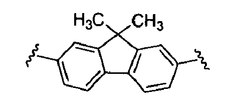 | 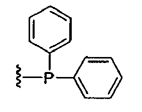 |
| 173 | 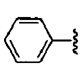 | 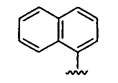 | 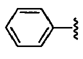 | 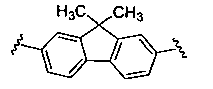 | 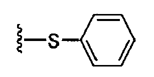 |
| 174 | 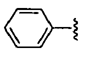 | 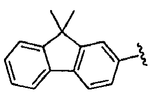 | 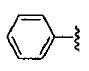 | 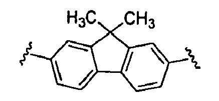 | 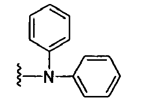 |
| 175 | 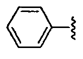 | 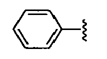 | 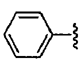 | 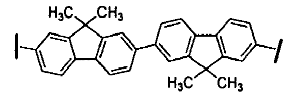 | 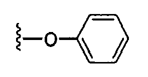 |
| 176 | 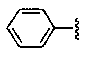 | 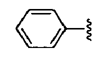 | 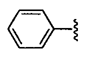 | 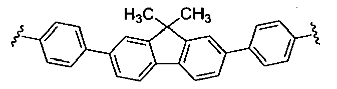 | 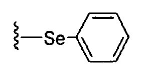 |
| 177 | 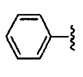 | 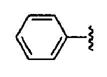 | 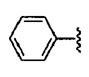 | 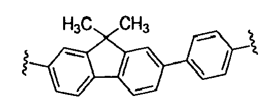 | 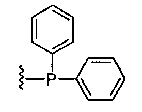 |
| 178 | 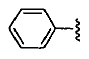 | 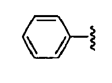 | 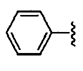 | 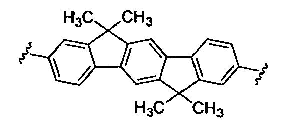 | 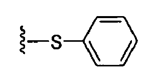 |
| 179 | 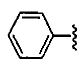 | 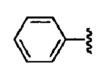 | 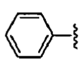 | 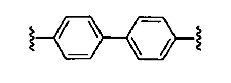 | 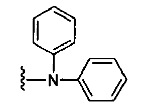 |
| 180 | 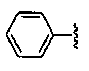 | 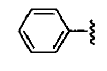 | 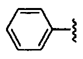 | 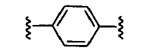 | 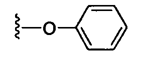 |
| 181 | 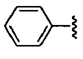 | 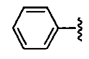 | 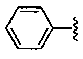 | 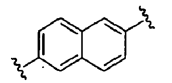 | 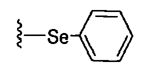 |
| 182 | 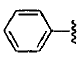 | 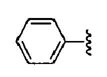 | 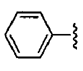 | 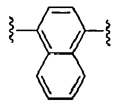 | 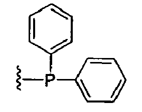 |
| 183 | 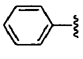 | 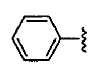 | 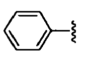 | 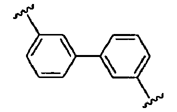 | 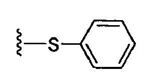 |
| 184 | 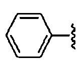 | 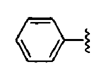 | 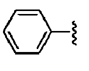 | 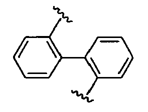 | 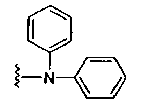 |
| 185 | 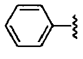 | 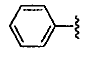 | 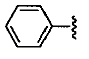 | 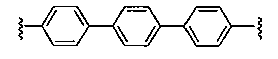 | 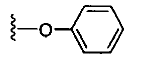 |
| 186 | 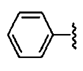 | 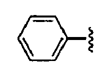 | 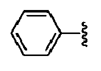 | 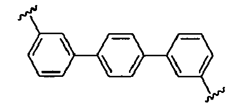 | 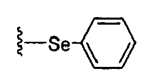 |
| 187 | 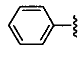 | 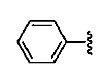 | 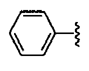 | 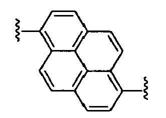 | 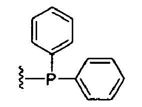 |
| 188 | 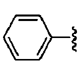 | 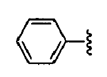 | 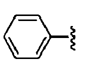 | 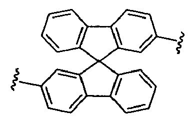 | 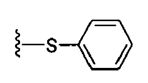 |
| 189 | 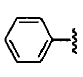 | 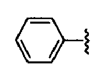 | 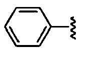 | 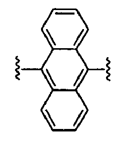 | 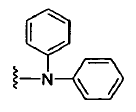 |
| 190 | 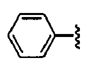 | 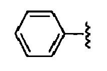 | 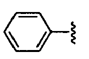 | 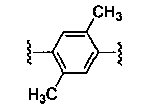 | 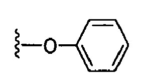 |
| 191 | 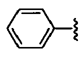 | 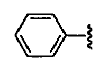 | 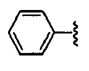 | 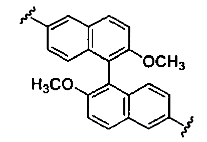 | 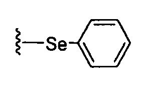 |
| 192 | 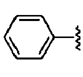 | 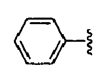 | 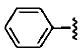 | 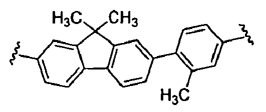 | 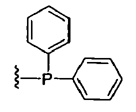 |
| 193 | 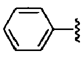 | 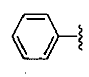 | 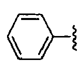 | 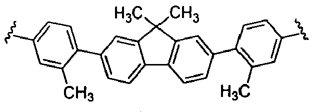 | 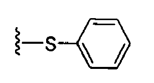 |
| 194 | 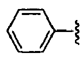 | 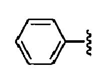 | 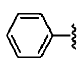 | 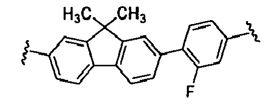 | 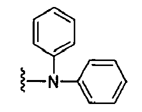 |
| 195 | 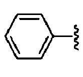 | 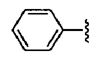 | 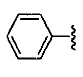 | 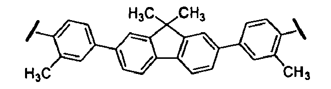 | 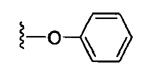 |
| 196 | 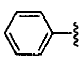 | 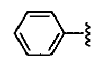 | 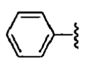 | 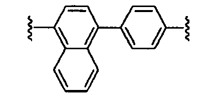 | 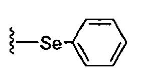 |
| 197 | 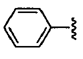 | 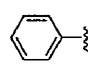 | 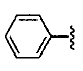 | 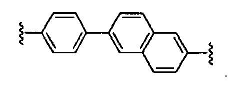 | 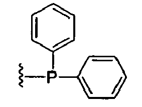 |
| 198 | 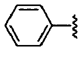 | 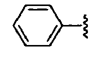 | 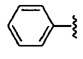 | 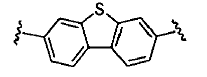 | 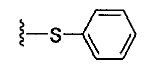 |
| 199 | 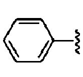 | 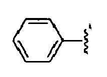 | 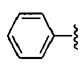 | 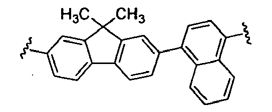 | 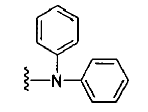 |
| 200 | 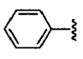 | 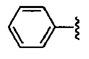 | 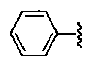 | 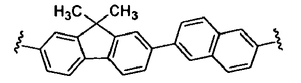 | 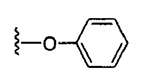 |
| 201 | 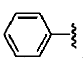 | 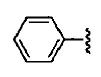 | 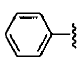 | 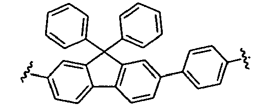 | 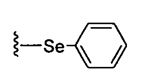 |
| 202 | 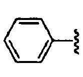 | 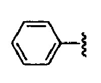 | 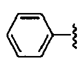 | 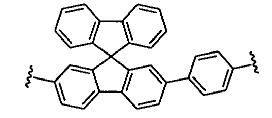 | 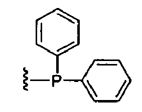 |
| 203 | 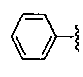 | 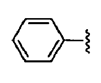 | 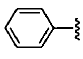 | 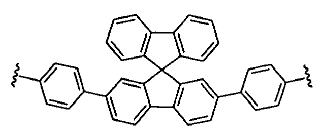 | 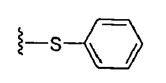 |
| 204 | 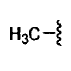 | 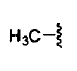 | 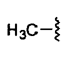 | 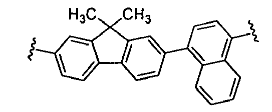 | 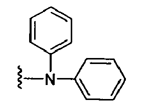 |
| 205 | 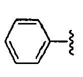 | 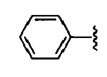 | 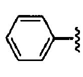 | 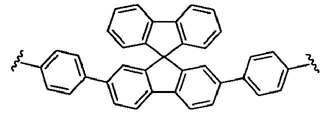 | 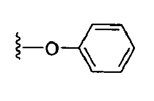 |
| 206 | 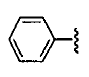 | 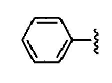 | 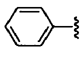 | 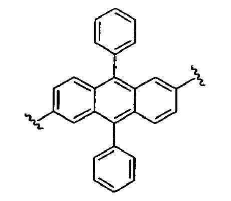 | 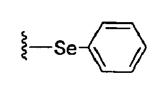 |
| 207 | 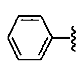 | 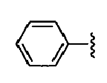 | 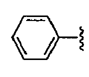 | 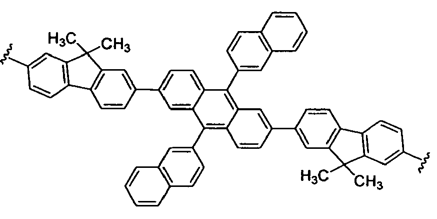 | 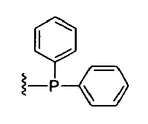 |
| 208 | 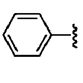 | 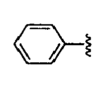 | 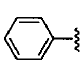 | 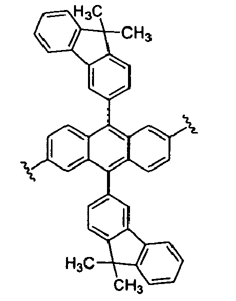 | 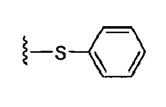 |
| 209 | 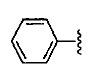 | 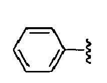 | 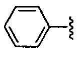 | 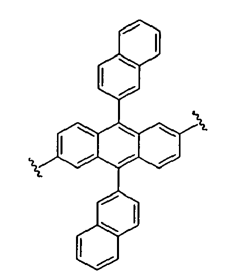 | 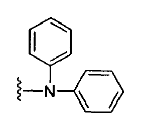 |
| 210 | 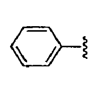 | 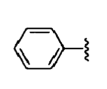 | 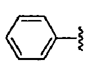 | 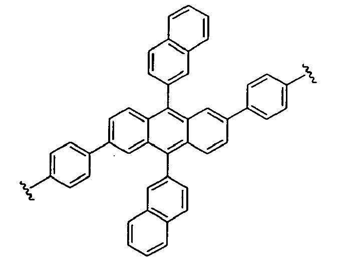 | 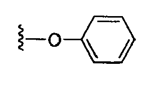 |
| 211 | 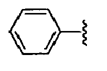 | 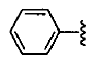 | 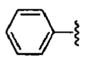 | 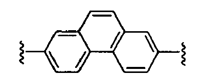 | 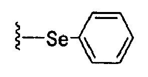 |
| 212 | 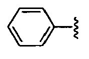 | 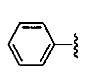 | 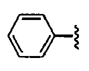 | 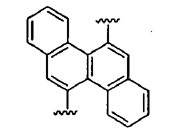 | 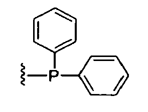 |
| 213 | 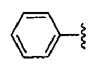 | 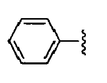 | 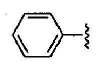 | 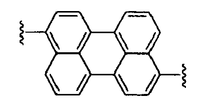 | 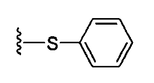 |
| 214 | 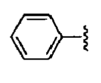 | 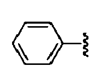 | 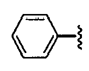 | 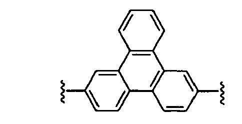 | 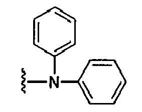 |
| 215 | 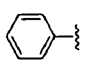 | 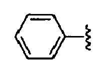 | 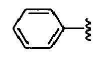 | 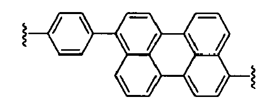 | 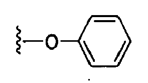 |
| 216 | 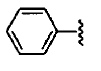 | 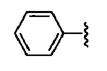 | 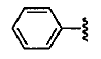 | 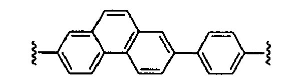 | 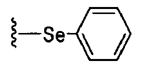 |
| 217 | 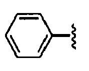 | 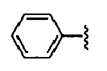 | 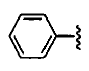 | 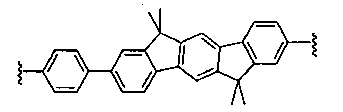 | 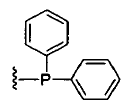 |
| 218 | 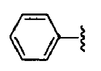 | 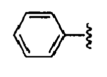 | 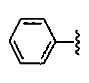 | 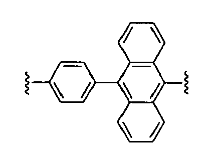 | 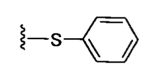 |
| 219 | 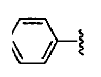 | 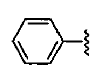 | 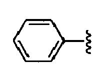 | 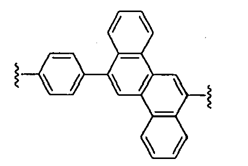 | 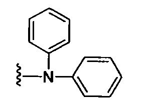 |
| 220 | 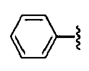 | 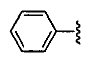 | 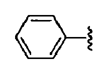 | 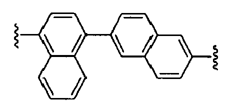 | 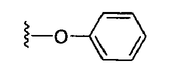 |
| 221 | 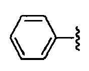 | 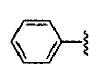 | 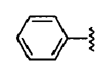 | 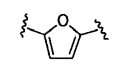 | 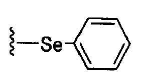 |
| 222 | 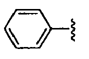 | 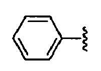 | 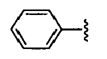 | 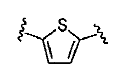 | 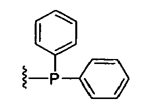 |
| 223 | 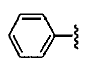 | 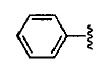 | 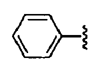 | 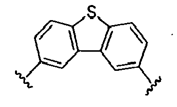 | 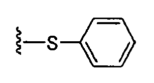 |
| 224 | 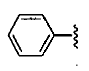 | 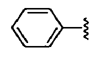 | 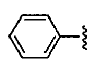 | 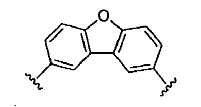 | 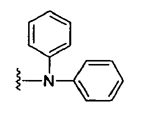 |
| 225 | 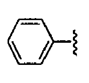 | 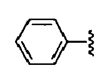 | 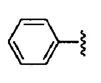 | 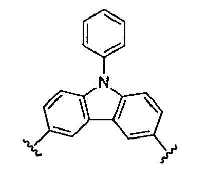 | 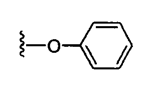 |

**Table 2**

| Compound | ¹H NMR |
|---|---|
| 102 | (300 MHz, COCl₃) : δ = 7.95 (m, 2H), 7.82 (m, 2H), 7.70 (m, 4H), 7.65 (m, 2H), 7.56 (m, 6H), 7.44 (m, 12H), 7.35 (m, 10H), 7.28 (m, 8H). |
| 103 | (300 MHz, CDCl₃) : δ = 7.91 (m, 2H), 7.85 (m, 2H), 7.73 (m, 4H), 7.61 (m, 2H), 7.52 (m, 4H), 7.40 (m, 12H), 7.31 (m, 18H). |
| 104 | (300 MHz, CDCl₃) : δ = 7.92 (m, 2H), 7.85 (m, 2H), 7.63 (m, 2H), 7.54 (m, 8H), 7.45 (m, 8H), 7.37 (m, 8H), 7.21 (m, 10H), 3.45 (s, 4H). |
| 105 | (300 MHz, CDCl₃) : δ = 7.92 (m, 2H), 7.83 (m, 2H), 7.71 (m, 4H), 7.62 (m, 2H), 7.55 (m, 6H), 7.44 (m, 6H), 7.37 (m, 18H), 1.67 (s, 6H). |
| 106 | (300 MHz, CDCl₃) : δ = 7.93 (m, 2H), 7.81 (m, 2H), 7.67 (m, 4H), 7.58 (m, 2H), 7.50 (m, 12H), 7.32 (m, 18H), 1.69 (s, 6H). |
| 107 | (300 MHz, CDCl₃) : δ = 7.94 (m, 4H), 7.82 (m, 6H), 7.65 (m, 4H), 7.53 (m, 2H), 7.44 (m, 4H), 7.34 (m, 10H), 7.27 (m, 10H), 1.72 (s, 6H), 1.67 (s, 6H), 1.56 (s, 6H). |
| 108 | (300 MHz, CDCl₃) : δ = 7.94 (m, 2H), 7.89 (m, 2H), 7.76 (m, 4H), 7.61 (m, 4H), 7.46 (m, 12H), 7.35 (m, 18H), 1.71 (s, 12H). |
| 109 | (300 MHz, CDCl₃) : δ = 7.91 (m, 2H), 7.78 (m, 2H), 7.59 (m, 10H), 7.46 (m, 12H), 7.39 (m, 18H), 1.67 (s, 6H). |
| 110 | (300 MHz, CDCl₃) : δ = 7.87 (m, 2H), 7.71 (m, 2H), 7.54 (m, 8H), 7.43 (m, 10H), 7.33 (m, 18H), 1.66 (s, 6H). |

### [Example 1-5] Manufacture of OLED's by using the compounds of the invention

An OLED device was manufactured by using the electroluminescent compound according to the invention.

First, a transparent electrode ITO thin film (15 Ω/□) prepared from glass for OLED was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) (of which the structure is shown below) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer having 60 nm of thickness on the ITO substrate.

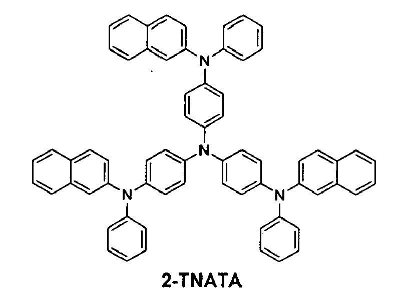

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer of 20 nm of thickness on the hole injection layer.

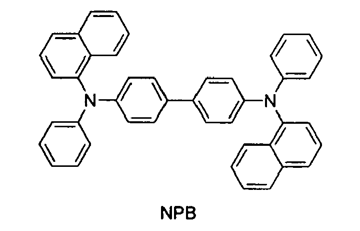

After forming the hole injection layer and hole transport layer, an electroluminescent layer was vapor-deposited as follows. To one cell of a vacuum vapor-deposit device, charged was a compound according to the present invention (e.g. Compound (101)), and perylene (of which the structure shown below) as a dopant material was charged to another cell. An electroluminescent layer was vapor-deposited with a thickness of 35 nm on the hole transport layer at a vapor-deposition rate of 100:1.

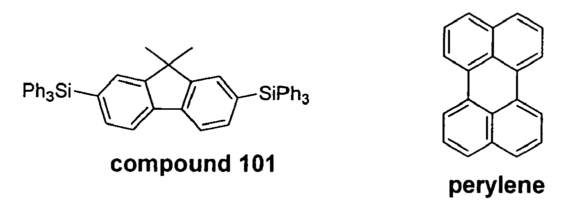

Then, tris(8-hydroxyquinoline)aluminum (III) (Alq) (of which the structure is shown below) was vapor-deposited as an electron transport layer with a thickness of 20 nm, and lithium quinolate (Liq) was vapor-deposited as an electron injection layer with a thickness of 1 to 2 nm. Thereafter, an Al cathode was vapor-deposited with a thickness of 150 nm by using another vacuum vapor-deposit device to manufacture an OLED.

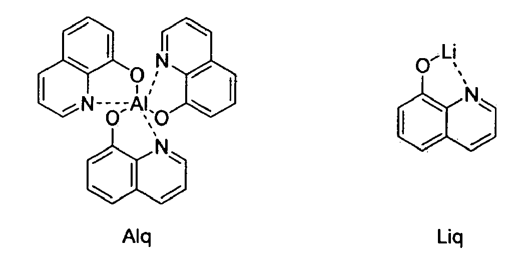

Each material employed for manufacturing an OLED was used as the electroluminescent material after purifying via vacuum sublimation under 10⁻⁶ torr.

### [Comparative Example 1] Manufacture of an OLED by using conventional electroluminescent material

After forming a hole injection layer and hole transport layer according to the same procedure described in Example 1, dinaphthylanthracene (DNA) was charged to one cell of said vacuum vapor-deposit device as a blue electroluminescent material, and perylene (of which the structure is shown below) was charged to another cell as another blue electroluminescent material. Then an electroluminescent layer having 30 nm of thickness was vapor-deposited on the hole transport layer at the vapor-deposition rate of 100:1.

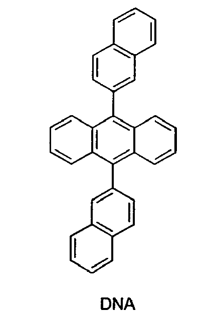

Then, an electron transport layer and electron injection layer were vapor-deposited according to the same procedure of Example 1, and an Al cathode was vapor-deposited thereon with a thickness of 150 nm by using another vacuum vapor-deposit device to manufacture an OLED.

### [Experimental Example 1] Determination of properties of OLED's manufactured

The blue luminous efficiencies of the OLED's comprising the organic EL compound according to the present invention (Examples 1 to 5) or conventional EL compound (Comparative Example 1) were measured at 500 cd/m² and 2,000 cd/m², respectively, and the results are shown in Table 3.

**Table 3**

| | Host | Dopant | Doping (wt%) | Luminous efficiency (cd/A) | | Color Conc. coordinate | EL color |
|---|---|---|---|---|---|---|---|
| | | | | @500 cd/m² | @2,000 cd/m² | | |
| Ex. 1 | Comp. 101 | perylene | 1 | 4.9 | 4.3 | (0.159, 0.188) | Blue |
| Ex. 2 | Comp. 104 | perylene | 1 | 4.6 | 4.0 | (0.160, 0.195) | Blue |
| Ex. 3 | Comp. 122 | perylene | 1 | 5.3 | 4.6 | (0.158, 0.190) | Blue |
| Ex. 4 | Comp. 136 | perylene | 1 | 5.3 | 5.2 | (0.155, 0.190) | Blue |
| Ex. 5 | Comp. 143 | perylene | 1 | 5.5 | 5.1 | (0.156, 0.186) | Blue |
| Comp. Ex. 1 | DNA | perylene | 1 | 4.4 | 3.6 | (0.160, 0.200) | Blue |

As can be seen from Table 3, it is found that the OLED's employing the organic EL compounds according to the present invention can afford higher luminous efficiency with better color coordinate as compared to the OLED employing DNA:perylene as conventional EL material that has been widely known. Further, since the electroluminescent material according to the invention exhibits better efficiency than conventional EL material from low luminance range (500 cd/m²) to high luminance range (2000 cd/m²), the EL material can be advantageous applied to panels of wide variety of sizes.

### [Example 6-7] Manufacture of OLED devices (2)

A phosphorescent OLED device was manufactured by using a compound according to the present invention.

First, a hole injection layer and a hole transport layer were formed according to the same procedure as Example 1, and Compound (101) according to the present invention was charged thereon, and Compound (G) (of which the structure is shown below) was added to another cell as dopant material. An EL layer having the thickness of 35 nm was vapor-deposited on the hole transport layer with 2 to 5% by weight of the vapor-deposition rate.

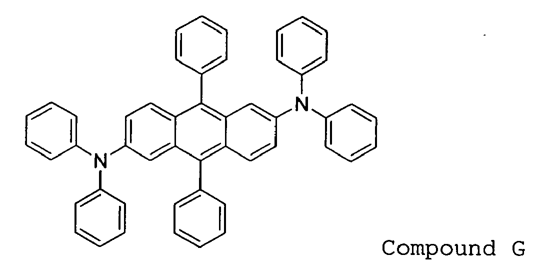

Then, an electron transport layer and electron injection layer were vapor-deposited according to the same procedure of Example 1, and an Al cathode was vapor-deposited thereon with a thickness of 150 nm by using another vacuum vapor-deposit device to manufacture an OLED.

### [Comparative Example 2] Manufacture of OLED device by using conventional EL material

After forming a hole injection layer and a hole transport layer according to the same procedure as Example 1, another cell of the vacuum vapor-deposition device was charged with DNPBA as EL host material, while Compound (G) was charged to still another cell. The two materials were evaporated at different rates to give doping at from 2 to 5% by weight on the basis of DNPBA. Thus an EL layer having the thickness of 30 nm was formed on the hole transport layer.

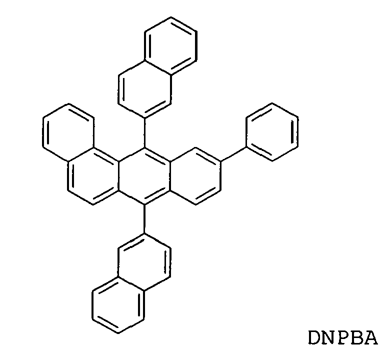

Then, an electron transport layer and electron injection layer were vapor-deposited according to the same procedure of Example 1, and an Al cathode was vapor-deposited thereon with a thickness of 150 nm by using another vacuum vapor-deposit device to manufacture an OLED.

### [Experimental Example 2] Determination of properties of OLED's manufactured

The green luminous efficiencies of the OLED's comprising the organic EL compound according to the present invention (Examples 6 and 7) or conventional EL compound (Comparative Example 2) were measured at 5,000 cd/m² and 20,000 cd/m², respectively, and the results are shown in Table 4.

**Table 4**

| | Host | Dopant | Doping Conc. (wt%) | Luminous efficiency (cd/A) | | Color coordinate | EL color |
|---|---|---|---|---|---|---|---|
| | | | | @500 cd/m² | @2,000 Cd/m² | | |
| Ex. 6 | Comp. 101 | Comp. G | 3 | 13.2 | 12.6 | (0.260, 0.630) | Green |
| Ex. 7 | Comp. 112 | Comp. G | 3 | 14.1 | 13.3 | (0.255, 0.625) | Green |
| Comp. Ex. 2 | DNPBA | Comp. G | 3 | 11.2 | 9.1 | (0.260, 0.620) | Green |

As can be seen from Table 4, it is found that the OLED's employing the organic EL compounds according to the present invention can afford higher luminous efficiency with better color coordinate as compared to the OLED employing DNPBA as conventional EL material. Further, since the electroluminescent material according to the invention exhibits better efficiency than conventional EL material in a broad range of luminance, as well as better properties in terms of device life, the EL material can be applied to panels of wide variety of sizes.

### [Examples 8-10] Manufacture of OLED's (3)

A phosphorescent OLED device was manufactured by using a compound according to the present invention.

First, a hole injection layer and a hole transport layer were formed according to the same procedure as Example 1, and Compound (101), a phosphorescent host compound according to the present invention, was charged thereon, and 1-phenyl isoquinoline as a red phosphorescent dopant was added to another cell. The two materials were doped by evaporation at different rates to give vapor-deposit of an EL layer having the thickness of 30 nm on the hole transport layer. The doping concentration is preferably from 4 to 10% by weight on the basis of the host.

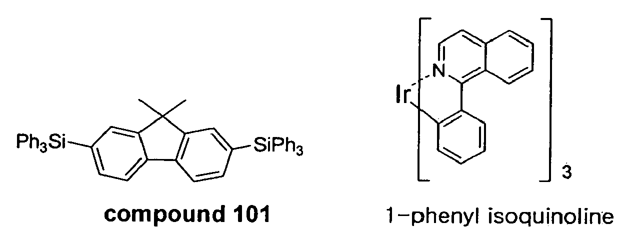

Then, an electron transport layer and electron injection layer were vapor-deposited according to the same procedure of Example 1, and an Al cathode was vapor-deposited thereon with a thickness of 150 nm by using another vacuum vapor-deposit device to manufacture an OLED.

### [Comparative Example 3] Manufacture of OLED device by using conventional EL material

After forming a hole injection layer and a hole transport layer according to the same procedure as Example 8, 4,4'-N,N'-dicarbazole-biphenyl (CBP) was charged thereon as EL host material, while 1-phenyl isoquinoline was charged to another cell as conventional red EL dopant. The two materials were evaporated at different rates to give doping and provide vapor-deposition of an EL layer having the thickness of 30 nm on the hole transport layer. The doping concentration preferably is from 4 to 10% by weight on the basis of the host.

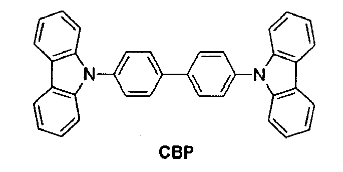

Then, bis(2-methyl-8-quinolinato)(p-phenylphenolato)aluminum (III) (BAlq) was vapor-deposited as a a hole blocking layer with a thickness of 10 nm, and a hole blocking layer, an electron transport layer and an electron injection layer were vapor-deposited according to the same procedure of Example 6. By using another vacuum vapor-deposit device, an Al cathode was vapor-deposited thereon with a thickness of 150 nm to manufacture an OLED.

### [Experimental Example 3] Determination of properties of OLED's manufactured

The operation voltage and red luminous efficiency of the OLED's comprising the organic EL compound according to the present invention (Examples 8 to 10) or conventional EL compound (Comparative Example 3) were measured at 10 mA/cm², respectively, and the results are shown in Table 5.

**Table 5**

| | Host | Dopant | blocking layer | Hole Operation voltage | Max. Luminous efficiency (cd/A) | Color coordinate | EL color |
|---|---|---|---|---|---|---|---|
| Ex. 8 | Comp. 101 | 1-phenyl isoquinoline | - | 7.1V | 7.8 | (0.68 0.31) | Red |
| Ex. 9 | Comp. 121 | 1-phenyl isoquinoline | - | 6.9V | 8.3 | (0.68 0.31) | Red |
| Ex. 10 | Comp. 136 | 1-phenyl isoquinoline | - | 7.2V | 8.1 | (0.68 0.31) | Red |
| Comp. Ex. 3 | CBP | 1-phenyl isoquinoline | BAlq | 8.0V | 8.0 | (0.67 0.32) | Red |

When Compounds (101), (121) and (136) according to the invention are employed, the device exhibits comparable efficiency properties to that using a conventional EL host, and provides good color coordinate. In addition, noticeable effect of lowered power consumption of the OLED due to lowered operation voltage by 0.8 to 1.1 V. If the host according to the invention is applied to mass production of OLED's, the time for mass production can be also shortened to give great benefit on the commercialization.

### [Examples 11-13] Manufacture of OLED's (4)

A phosphorescent OLED device was manufactured by using a compound according to the present invention.

First, a hole injection layer and a hole transport layer were formed according to the same procedure as Example 1, and Compound (112), a phosphorescent host compound according to the present invention, was charged thereon, and Ir(ppy)₃ was added to another cell as a green electroluminescent dopant. The two materials were doped by evaporation at different rates to give vapor-deposit of an EL layer having the thickness of 30 nm on the hole transport layer. The doping concentration is preferably from 4 to 10% by weight on the basis of the host.

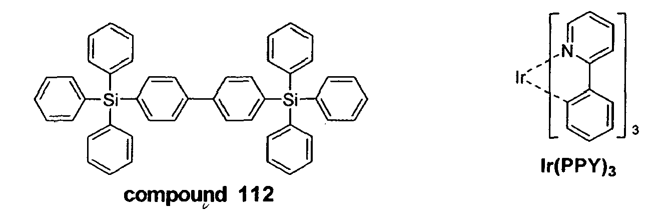

Then, a hole blocking layer, an electron transport layer and an electron injection layer were vapor-deposited according to the same procedure as Example 1, and an Al cathode was vapor-deposited thereon with a thickness of 150 nm by using another vacuum vapor-deposit device to manufacture an OLED.

### [Comparative Example 4] Manufacture of OLED device by using conventional EL material

After forming a hole injection layer and a hole transport layer according to the same procedure as Example 9, 4,4'-N,N'-dicarbazole-biphenyl (CBP) as EL host material was charged thereon, while Ir(ppy)₃ as conventional green EL dopant was charged to another cell. The two materials were evaporated at different rates to give doping to provide vapor-deposition of an EL layer having the thickness of 30 nm on the hole transport layer. The doping concentration preferably is from 4 to 10% by weight on the basis of the host.

### [Experimental Example 4] Determination of properties of OLED's manufactured

The operation voltage and green luminous efficiency of the OLED's comprising the organic EL compound according to the present invention (Examples 11 to 13) or conventional EL compound (Comparative Example 4) were measured at 10 mA/cm², respectively, and the results are shown in Table 6.

**Table 6**

| | Host | Dopant | Hole blocking layer | Operation voltage | Max. Luminous efficiency (cd/A) | olor coordinate | EL color |
|---|---|---|---|---|---|---|---|
| Ex. 11 | Comp. 112 | Ir(ppy)₃ | - | 6.7 V | 26.2 | (0.281 0.606) | Green |
| Ex. 12 | Comp. 118 | Ir(ppy)₃ | - | 6.9 V | 25.4 | (0.281 0.607) | Green |
| Ex. 13 | Comp. 124 | Ir(ppy)₃ | - | 6.7 V | 26.0 | (0.279 0.605) | Green |
| Comp. Ex. 4 | CBP | Ir(ppy)₃ | BAlq | 7.5 V | 25.1 | (0.302 0.604) | Green |

The device employing the compound according to the present invention as phosphorescent host showed no change of position of main EL peak, but significantly decreased x-value of the color coordinate with reduced FWHM, as compared to the device employing CBP as conventional EL host material. In addition, the device was operated at a lower voltage by at least 0.6 V as compared to the device employing CBP as host material. Thus, when the compound according to the present invention is employed as green phosphorescent host, the power consumption could be lowered as compared to the device employing conventional material. The green phosphorescent host according to the invention is advantageous in that the device exhibits excellent luminous efficiency if not using a hole blocking layer, so that the steps for manufacturing an OLED can be simplified.

## Claims

1. An organic electroluminescent compound represented by Chemical Formula (1): 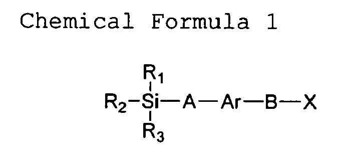 wherein,
A and B independently represent a chemical bond, or (C6-C60)arylene with or without one or more substituent(s) selected from linear or branched and saturated or unsaturated (C1-C60)alkyl with or without halogen substituent(s), (C1-C30)alkoxy, (C6-C60)aryl, (C5-C60)heteroaryl and halogen, excluding the case wherein both A and B represent anthrylene;
Ar represents (C6-C60)arylene or (C5-C60)heteroarylene, provided that Ar necessarily represents 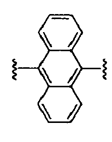 when both A and B represent chemical bonds;
the arylene or heteroarylene of Ar may be further substituted by one or more substituent(s) selected from deuterium, linear or branched and saturated or unsaturated (C1-C60)alkyl with or without halogen substituent(s), (C1-C30)alkoxy, (C6-C60)aryl, (C5-C60)heteroaryl and halogen;
R₁ through R₃ independently represent linear or branched and saturated or unsaturated (C1-C60)alkyl, (C6-C60)aryl or (C5-C60)heteroaryl; and the alkyl or aryl of R₁ through R₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl;
X represents 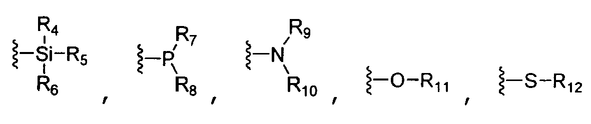 or 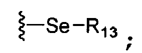 and
R₄ through R₁₃ independently represent linear or branched and saturated or unsaturated (C1-C60)alkyl, (C6-C60)aryl or (C5-C60)heteroaryl; and the alkyl or aryl of R₄ through R₁₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl.

2. The organic electroluminescent compound according to claim 1, wherein the arylene or heteroarylene of Ar is selected from from the following structures: 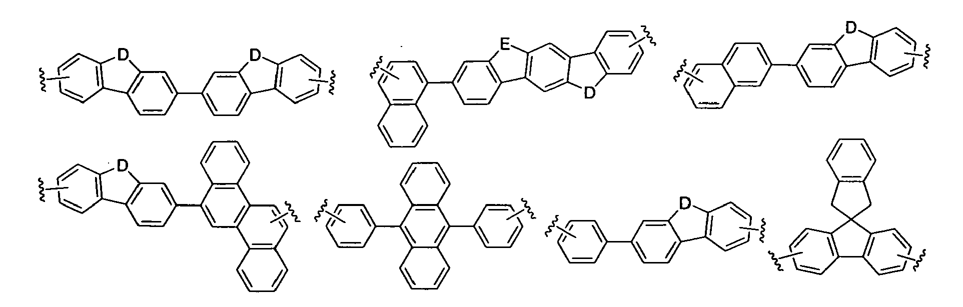 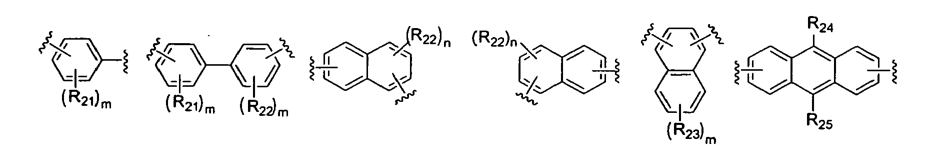 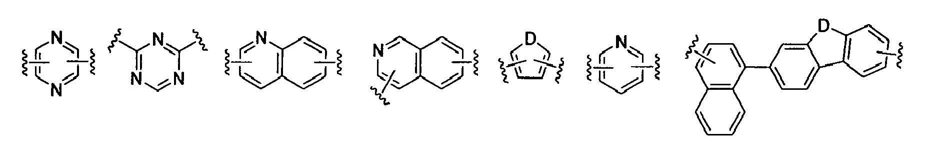 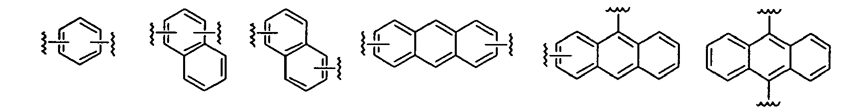 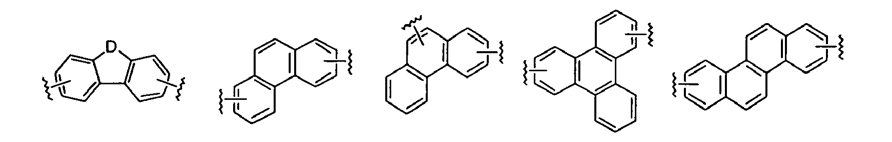 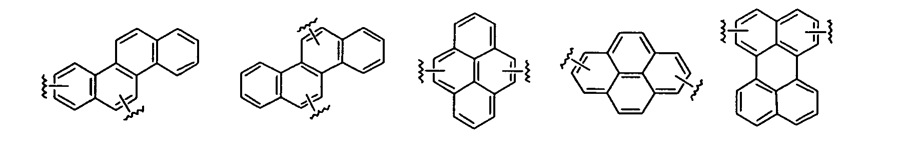 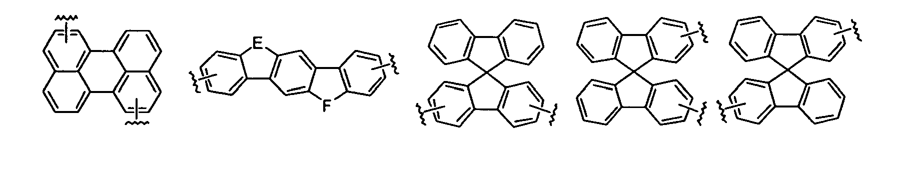 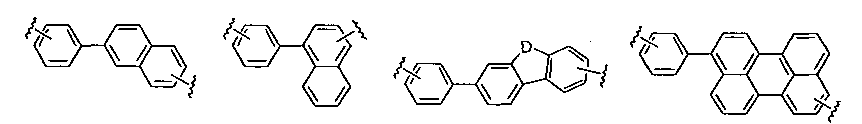 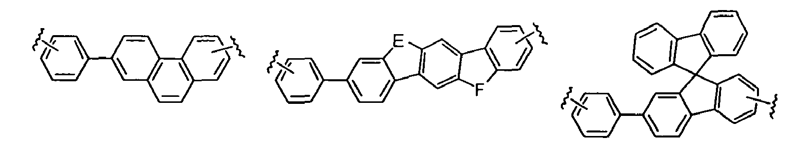 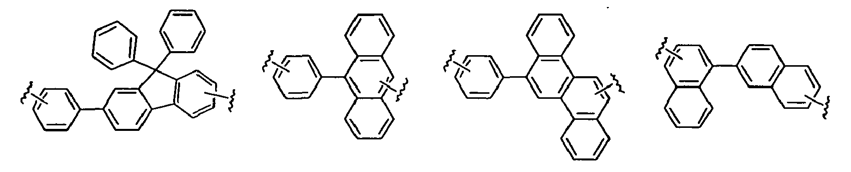 wherein, D, E and F independently represent CR₃₁R₃₂, NR₃₃, O or S,
R₂₁, R₂₂, R₂₃, R₂₄ and R₂₅ independently represent linear or branched and saturated or unsaturated (C1-C60)alkyl, (C1-C30)alkoxy, halogen or (C6-C60)aryl;
R₃₁, R₃₂ and R₃₃ independently represent linear or branched and saturated or unsaturated (C1-C60)alkyl or (C6-C60)aryl;
the alkyl, alkoxy or aryl of R₂₁, R₂₂, R₂₃, R₂₄, R₂₅, R₃₁, R₃₂ and R₃₃ may be further substituted by halogen, or linear or branched (C1-C60)alkyl;
m is an integer from 0 to 4; and
n is an integer from 0 to 3.

3. An organic light emitting diode which is comprised of a first electrode; a second electrode; and at least one organic layer(s) interposed between the first electrode and the second electrode; wherein the organic layer comprises one or more organic electroluminescent compound(s)represented by Chemical Formula (1): 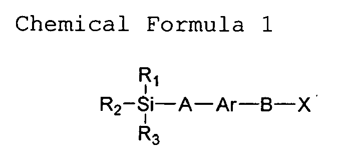 wherein,
A and B independently represent a chemical bond, or (C6-C60)arylene with or without one or more substituent(s) selected from linear or branched and saturated or unsaturated (C1-C60)alkyl with or without halogen substituent(s), (C1-C30)alkoxy, (C6-C60)aryl, (C5-C60)heteroaryl and halogen, excluding the case wherein both A and B represent anthrylene;
Ar represents (C6-C60)arylene or (C5-C60)heteroarylene, provided that Ar necessarily represents 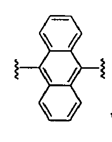 when both A and B represent chemical bonds;
the arylene or heteroarylene of Ar may be further substituted by one or more substituent(s) selected from deuterium, linear or branched and saturated or unsaturated (C1-C60)alkyl with or without halogen substituent(s), (C1-C30)alkoxy, (C6-C60)aryl, (C5-C60)heteroaryl and halogen;
R₁ through R₃ independently represent linear or branched and saturated or unsaturated (C1-C60)alkyl, (C6-C60)aryl or (C5-C60)heteroaryl; and the alkyl or aryl of R₁ through R₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl;
X represents 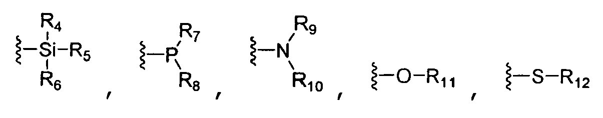 or 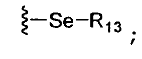 and
R₄ through R₁₃ independently represent linear or branched and saturated or unsaturated (C1-C60)alkyl, (C6-C60)aryl or (C5-C60)heteroaryl; and the alkyl or aryl of R₄ through R₁₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl and one or more dopant(s) selected from the compounds represented by one of Chemical Formulas (2) to (7): 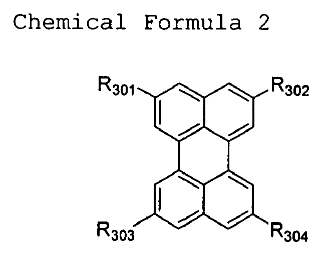 In Chemical Formula (2), R₃₀₁ through R₃₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkyloxy, aryloxy, arylthio, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(Cl-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C1-C60)alkylthio, (C6-C60)arylthio, (C1-C60)alkoxycarbonyl, (C1-C60)alkylcarbonyl, (C6-C60)arylcarbonyl, carboxyl, nitro and hydroxyl. 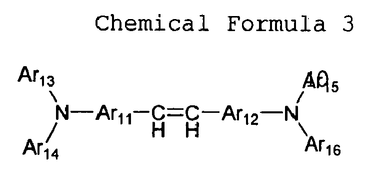 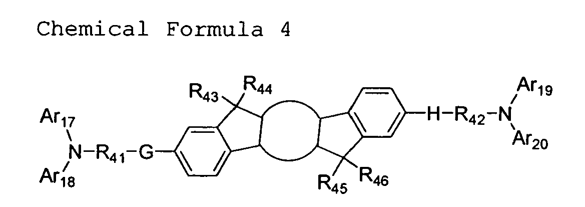 In Chemical Formula (3) and (4), Ar₁₁ and Ar₁₂ independently represent substituted or unsubstituted (C6-C60)arylene, substituted or unsubstituted (C5-C60)heteroarylene, or indenofluorene, fluorene or spirofluorene shown below: 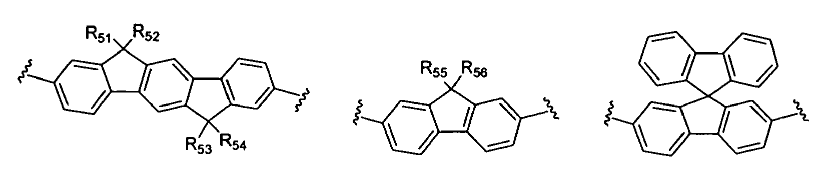 Ar₁₃ through Ar₁₆ are independently selected from (C6-C60)aromatic rings, (C5-C60)heteroaromatic rings and polycyclic aromatic rings; provided that Ar₁₁ and Ar₁₂ may be same or different, Ar₁₃ and Ar₁₅ may be same or different, and Ar₁₄ and Ar₁₆ may be same or different;
Ar₁₇ through Ar₂₀ independently represent a (C5-C60)aromatic ring, a (C5-C60)heteroaromatic ring, or a fused polycyclic aromatic ring with two or more aromatic rings being fused; 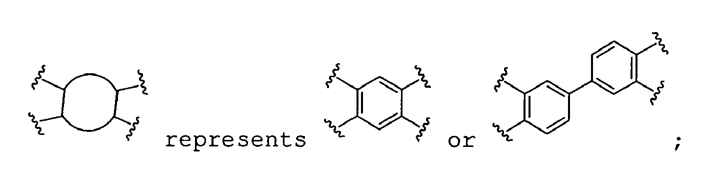 G and H independently represent a chemical bond, 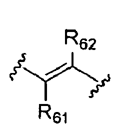 or 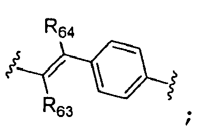 R₄₁ and R₄₂ independently represent (C5-C60)aromatic ring, (C5-C60)heteroaromatic ring, or a fused polycyclic aromatic ring with two or more aromatic rings being fused;
R₄₃ through R₄₆ independently represent linear or branched (C1-C60)alkyl with or without halogen, substituted or unsubstituted (C6-C50)aryl, substituted or unsubstituted (C5-C50)heteroaryl, or halogen;
R₅₁ through R₅₆ are independently selected from (C1-C60)alkyl, substituted or unsubstituted (C6-C50)aryl, substituted or unsubstituted (C5-C50)heteroaryl, halogen, and phenyl or naphthyl with or without (Cl-C60)alkyl substituent; and
R₆₁ through R₆₄ independently represent hydrogen, deuterium, halogen or (C5-C60)aromatic ring; 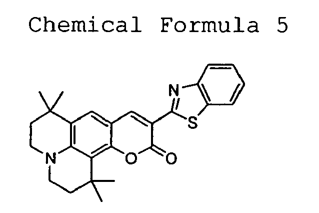 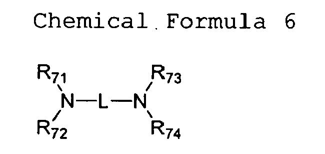 In Chemical Formula (6),
L represents (C6-C60)arylene with or without one or more substituent(s) selected from a group consisting of hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; and the alkyl, cycloalkyl, heterocycloalkyl, aryl, heteroaryl, arylsilyl, aryloxy, alkyloxy, arylthio, alkylthio, alkylsilyl, alkylamino and arylamino substituent on the arylene may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₇₁ through R₇₄ independently represent hydrogen, halogen, deuterium, (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, adamantyl, (C3-C60)cycloalkyl, or each of R₇₁ through R₇₄ may be linked to an adjacent substituent via (C3-C60)alkylene or (C3-C60)alkenylene with or without a fused ring to form an alicyclic ring, or a monocyclic or polycyclic aromatic ring; and
the alkyl, aryl, heteroaryl, arylamino, alkylamino, cycloalkyl and heterocycloalkyl of R₇₁ through R₇₄ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Chemical Formula 7 M¹L¹L²L³
wherein, M¹ is selected from a group consisting of metals from Group 7, 8, 9, 10, 11, 13, 14, 15 and 16 of the Periodic Table of Elements. Ligands, L¹, L² and L³ are independently selected from the following structures: 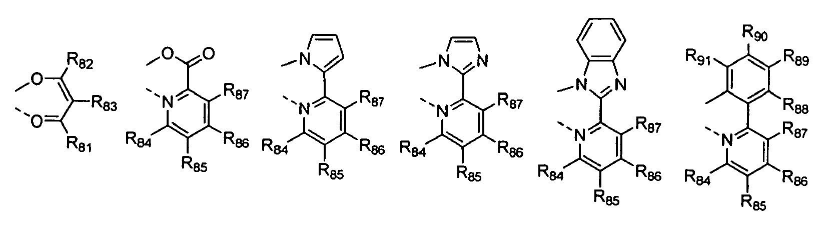 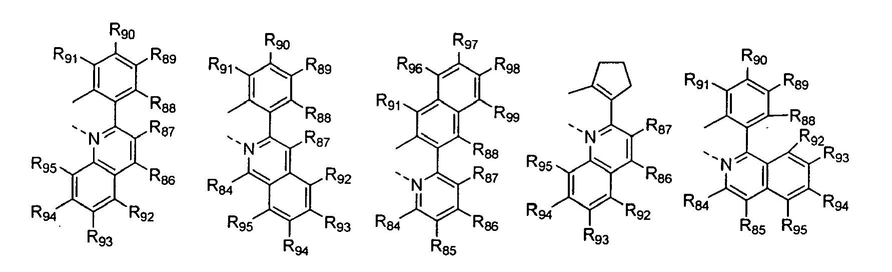 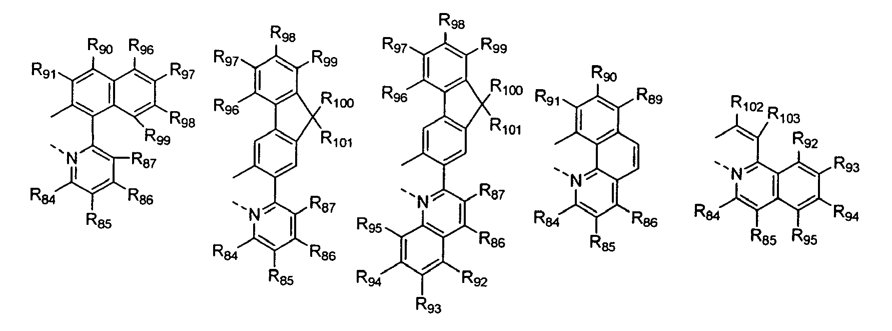 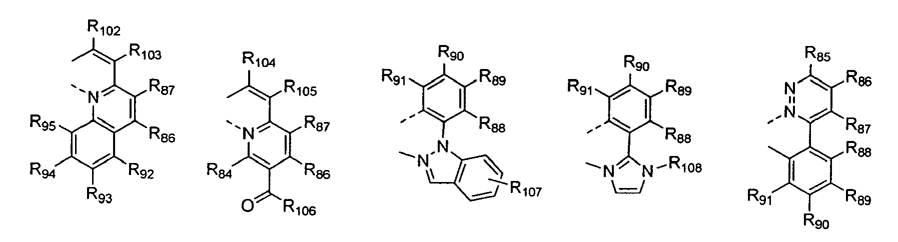 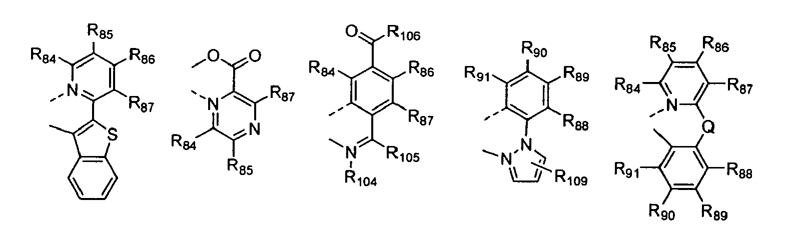 wherein, R₈₁ through R₈₃ independently represent hydrogen, deuterium, (Cl-C60)alkyl with or without halogen substituent(s), (C6-C60)aryl with or without (C1-C60)alkyl substituent, or halogen;
R₈₄ through R₉₉ independently represent hydrogen, deuterium, (C1-C60)alkyl, (C1-C30)alkoxy, (C3-C60)cycloalkyl, (C2-C30)alkenyl, (C6-C60)aryl, mono or di(Cl-C30)alkylamino, mono or di(C6-C30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₈₄ through R₉₉ may be further substituted by one or more substituent(s) selected from deuterium, (C1-C60)alkyl, (C6-C60)aryl and halogen;
R₁₀₀ through R₁₀₃ independently represent hydrogen, deuterium, (C1-C60)alkyl with or without halogen substituent(s), or (C6-C60)aryl with or without (C1-C60)alkyl substituent;
R₁₀₄ and R₁₀₅ independently represent hydrogen, deuterium, (C1-C60)alkyl, (C6-C60)aryl or halogen, or R₁₀₄ and R₁₀₅ may be linked via (C3-C12)alkylene or (C3-C12)alkenylene with or without a fused ring to form an alicyclic ring, or a monocyclic or polycyclic aromatic ring; and the alkyl or aryl of R₁₀₄ and R₁₀₅, or the alicyclic ring, or the monocyclic or polycyclic aromatic ring formed therefrom by linkage via (C3-C12)alkylene or (C3-C12)alkenylene with or without a fused ring may be further substituted by one or more substituent(s) selected from deuterium, (C1-C60)alkyl with or without halogen substituent(s), (C1-C30)alkoxy, halogen, tri(C1-C30)alkylsilyl, tri(C6-C30)arylsilyl and (C6-C60)aryl;
R₁₀₆ represents (C1-C60)alkyl, (C6-C60)aryl, (C5-C60)heteroaryl or halogen;
R₁₀₇ through R₁₀₉ independently represent hydrogen, deuterium, (C1-C60)alkyl, (C6-C60)aryl or halogen, and the alkyl or aryl of R₁₀₆ through R₁₀₉ may be further substituted by halogen or (C1-C60)alkyl; and
Q represents 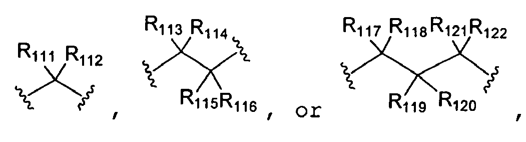 wherein R₁₁₁ through R₁₂₂ independently represent hydrogen, deuterium, (C1-C60)alkyl with or without halogen substituent(s), (C1-C30)alkoxy, halogen, (C6-C60)aryl, cyano or (C5-C60)cycloalkyl, or each of R₁₁₁ through R₁₂₂ may be linked to an adjacent substituent via alkylene or alkenylene to form a (C5-C7)spiro ring or a (C5-C9)fused ring, or may be linked with R₈₇ or R₈₈ via alkylene or alkenylene to form a (C5-C7)fused ring.

4. The organic light emitting diode according to claim 3, wherein the organic layer comprises one or more compound(s) selected from a group consisting of arylamine compounds and styrylarylamine compounds.

5. The organic light emitting diode according to claim 3, wherein the organic layer comprises one or more metal(s) selected from a group consisting of organic metals of Group 1, Group 2, 4^{th} period and 5^{th} period transition metals, lanthanide metals and d-transition elements.

6. The organic light emitting diode according to claim 3, wherein the organic layer comprises an electroluminescent layer and a charge generating layer.

7. The organic light emitting diode according to claim 3, wherein a mixed region of reductive dopant and organic substance, or a mixed region of oxidative dopant and organic substance is placed on the inner surface of one or both electrode(s) among the pair of electrodes.

8. An organic solar cell which comprises an organic electroluminescent compound represented by Chemical Formula (1): 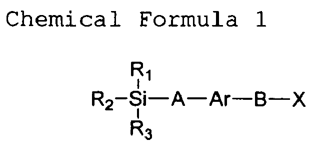 wherein,
A and B independently represent a chemical bond, or (C6-C60)arylene with or without one or more substituent(s) selected from linear or branched and saturated or unsaturated (C1-C60)alkyl with or without halogen substituent(s), (C1-C30)alkoxy, (C6-C60)aryl, (C5-C60)heteroaryl and halogen, excluding the case wherein both A and B represent anthrylene;
Ar represents (C6-C60)arylene or (C5-C60)heteroarylene, provided that Ar necessarily represents 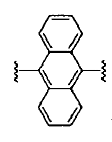 when both A and B represent chemical bonds;
the arylene or heteroarylene of Ar may be further substituted by one or more substituent(s) selected from deuterium, linear or branched and saturated or unsaturated (C1-C60)alkyl with or without halogen substituent(s), (C1-C30)alkoxy, (C6-C60)aryl, (C5-C60)heteroaryl and halogen;
R₁ through R₃ independently represent linear or branched and saturated or unsaturated (C1-C60)alkyl, (C6-C60)aryl or (C5-C60)heteroaryl; and the alkyl or aryl of R₁ through R₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl;
X represents 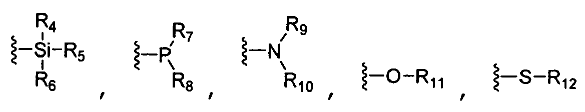 or 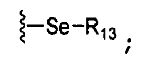 and
R₄ through R₁₃ independently represent linear or branched and saturated or unsaturated (C1-C60)alkyl, (C6-C60)aryl or (C5-C60)heteroaryl; and the alkyl or aryl of R₄ through R₁₃ may be further substituted by one or more substituent(s) selected from deuterium, linear or branched and saturated or unsaturated (C1-C60)alkyl, (C1-C30)alkoxy, (C6-C60)aryl, (C5-C60)heteroaryl, halogen, phenyl, naphthyl and anthryl.
